# EUROPEAN PATENT APPLICATION

(11) **EP 4 571 353 A1**
(43) Date of publication of application: **18.06.2025**
(21) Application number: 24177567.5
(22) Date of filing: 23.05.2024
(51) Int. Cl.: G01S 7/481, G01S 17/10, G01S 7/4865

(54) **LIGHT EMITTING DEVICE AND DISTANCE MEASUREMENT APPARATUS**

(30) Priority: 13.12.2023 JP 2023210101
(71) Applicant: FUJIFILM Business Innovation Corp., Minato-ku Tokyo (JP)
(72) Inventor: YAMAMOTO, Yoshihiro, Yokohama-shi, Kanagawa (JP); HAYAKAWA, Junichiro, Ebina-shi, Kanagawa (JP); IGUCHI, Daisuke, Ebina-shi, Kanagawa (JP); SAKITA, Tomoaki, Ebina-shi, Kanagawa (JP); TAKEYAMA, Kei, Ebina-shi, Kanagawa (JP)
(74) Representative: Kurig, Thomas

(57) **Abstract**

A light emitting device includes a light emitting unit that emits light, an optical system that expands an irradiation range of the light emitted from the light emitting unit as a distance from the light emitting unit increases, and plural light sources each having the light emitting unit and the optical system and irradiating different irradiation regions with light beams, in which center lines of the light beams emitted from the light sources to the irradiation regions intersect each other.

## Description

### BACKGROUND OF THE INVENTION

### (i) Field of the Invention

The present invention relates to a light emitting device and a distance measurement apparatus.

### (ii) Description of Related Art

JP2020-191268A discloses a vehicular lamp including a plurality of light sources and a plurality of projection optical systems corresponding to the plurality of light sources, in which at least one light source among the plurality of light sources is disposed in a state of being shifted with respect to an optical axis of the projection optical system corresponding to the light source.

### SUMMARY OF THE INVENTION

There is a distance measurement apparatus that measures a distance to a target object based on a result of irradiating the target object with light from a light emitting device and receiving light reflected by the target object.

In a case where a light emitting device that irradiates different irradiation regions with light beams using a plurality of light sources is used, a non-irradiation region, which is not irradiated with light, may be formed between the irradiation regions that are irradiated with light beams from the respective light sources. In the non-irradiation region, the target object is not irradiated with light, which makes it difficult for the distance measurement apparatus to measure the distance to the target object.

An object of the present invention is to prevent a non-irradiation region, which is not irradiated with light, from being formed between different irradiation regions in a case where the irradiation regions are irradiated with light beams using a plurality of light sources, as compared with a case where center lines of the light beams emitted from the plurality of light sources to the irradiation regions do not intersect each other.

According to a first aspect of the present disclosure, there is provided a light emitting device including a light emitting unit that emits light, an optical system that expands an irradiation range of the light emitted from the light emitting unit as a distance from the light emitting unit increases, and a plurality of light sources each having the light emitting unit and the optical system and irradiating different irradiation regions with light beams, in which center lines of the light beams emitted from the light sources to the irradiation regions intersect each other.

According to a second aspect of the present disclosure, in the light emitting device according to the first aspect, the light emitting device may further include a housing that accommodates the plurality of light sources, and an intersection portion where the center lines of the light beams emitted from the plurality of light sources to the irradiation regions intersect each other may be located inside the housing.

According to a third aspect of the present disclosure, in the light emitting device according to the first aspect or the second aspect, the light emitting unit of each of the light sources may include a plurality of light emitting sections that irradiate, with light beams, a plurality of irradiation sections into which an irradiation region is divided, the light emitting device may further include a drive unit that drives the light emitting unit of each of the light sources to individually turn on the plurality of light emitting sections of the light emitting unit, and the drive unit may not simultaneously turn on the light emitting sections that irradiate, with light beams, the irradiation sections adjacent to each other in the different irradiation regions.

According to a fourth aspect of the present disclosure, in the light emitting device according to the third aspect, in the irradiation sections where the light beams emitted from the light sources to the irradiation regions overlap, the drive unit may turn on a light emitting section of one light source that irradiates a first irradiation section, which is one of the irradiation sections, with light, may not turn on a light emitting section of the other light source that irradiates a second irradiation section, which is the other of the irradiation sections, with light, and may turn on light emitting sections that irradiate, with light beams, irradiation sections other than the first irradiation section and the second irradiation section.

According to a fifth aspect of the present disclosure, in the light emitting device according to the third aspect, the drive unit may turn on the light emitting sections that irradiate, with light beams, the irradiation sections adjacent to each other in the different irradiation regions, with a temporal shift.

According to a sixth aspect of the present disclosure, in the light emitting device according to any one of the first aspect to the fifth aspect, optical systems and light emitting units of the plurality of light sources may have the same characteristics, and the plurality of light sources may have different relative positions of the optical system and the light emitting unit so that there is no gap between the different irradiation regions in a case where a distance from the plurality of light sources is a predetermined reference distance.

According to a seventh aspect of the present disclosure, in the light emitting device according to any one of the first aspect to the six aspect, the plurality of light sources may include a first light source, and a plurality of second light sources that are arranged in a first direction intersecting an optical axis of the optical system with respect to the first light source, and a center line of light emitted from the first light source may intersect any of center lines of light beams emitted from the plurality of second light sources.

According to an eighth aspect of the present disclosure, in the light emitting device according to the seventh aspect, positions of intersection portions where the center line of the light emitted from the first light source and the center lines of the light beams emitted from the respective second light sources intersect each other may be coincident.

According to a ninth aspect of the present disclosure, in the light emitting device according to any one of the first aspect to the sixth aspect, the plurality of light sources may include a first light source, a second light source that is arranged in a first direction intersecting an optical axis of the optical system with respect to the first light source, and a third light source that is arranged in a second direction intersecting the optical axis and the first direction with respect to the first light source, and a center line of light emitted from the first light source may intersect at least one of a center line of light emitted from the second light source or a center line of light emitted from the third light source.

According to a tenth aspect of the present disclosure, in the light emitting device according to the ninth aspect, the center line of the light emitted from the first light source may intersect both the center line of the light emitted from the second light source and the center line of the light emitted from the third light source.

According to an eleventh aspect of the present disclosure, there is provided a light emitting device including a light emitting unit that emits light, an optical system that expands an irradiation range of the light emitted from the light emitting unit as a distance from the light emitting unit increases, and a plurality of light sources each having the light emitting unit and the optical system and irradiating different irradiation regions with light beams, in which an arrangement of the plurality of light sources and an arrangement of a plurality of irradiation regions that are irradiated with light beams from the plurality of light sources on an irradiation surface that is at a predetermined distance from the plurality of light sources and that is irradiated with light beams from the light sources are reversed.

According to a twelfth aspect of the present disclosure, there is provided a distance measurement apparatus including the light emitting device according to any one of the first aspect to the eleventh aspect, a light receiving unit that receives light emitted from the light emitting device and reflected by a target object, and a distance measurement unit that measures a distance to the target object based on a result of the light reception by the light receiving unit.

According to a thirteenth aspect of the present disclosure, in the distance measurement apparatus according to the twelfth aspect, the light receiving unit may receive reflected light at a position farther from the light emitting device than an intersection portion where the center lines of the light beams emitted from the plurality of light sources to the irradiation regions intersect each other.

According to the first aspect, the eleventh aspect, and the twelfth aspect of the present disclosure, it is possible to prevent a non-irradiation region, which is not irradiated with light, from being formed between different irradiation regions in a case where the irradiation regions are irradiated with light beams using the plurality of light sources, as compared with a case where the center lines of the light beams emitted from the plurality of light sources to the irradiation regions do not intersect each other.

According to the second aspect of the present disclosure, it is possible to prevent the target object from being irradiated with an excessive amount of light as compared with a case where the intersection portion where the center lines of the light beams emitted from the plurality of light sources to the irradiation regions intersect each other is located outside the housing.

According to the third aspect of the present disclosure, it is possible to prevent the amount of light beams emitted to the irradiation regions from being non-uniform as compared with a case where the light emitting sections that irradiate, with light beams, the irradiation sections adjacent each other in the different irradiation regions are simultaneously turned on.

According to the fourth aspect of the present disclosure, it is possible to reduce a time required to irradiate all the irradiation sections with light beams in a case where the light emitting section of one light source that irradiates the first irradiation section with light is turned on, and the light emitting section of the other light source that irradiates the second irradiation section with light is not turned on, as compared with a case where the light emitting sections that irradiate, with light beams, the irradiation sections other than the first irradiation section and the second irradiation section are not turned on.

According to the fifth aspect of the present disclosure, it is possible to prevent occurrence of an irradiation section, which is not irradiated with light, as compared with a case where the light emitting sections that irradiate, which light beams, the irradiation sections adjacent to each other in the different irradiation regions are not turned on with a temporal shift.

According to the sixth aspect of the present disclosure, the non-irradiation region is less likely to be formed between the irradiation regions adjacent to each other as compared with a case where the relative positions of the optical system and the light emitting unit are not determined so that there is no gap between the different irradiation regions.

According to the seventh aspect of the present disclosure, it is possible to narrow a range in which the non-irradiation region is formed as compared with a case where the center line of the light emitted from the first light source intersects only any one of the center lines of the light beams emitted from the plurality of second light sources.

According to the eighth aspect of the present disclosure, it is possible to further narrow the range in which the non-irradiation region is formed as compared with a case where the positions of the intersection portions where the center line of the light emitted from the first light source and the center lines of the light beams emitted from the respective second light sources intersect each other are not coincident.

According to the ninth aspect of the present disclosure, it is possible to narrow the range in which the non-irradiation region is formed as compared with a case where the center line of the light emitted from the first light source does not intersect the center line of the light emitted from the second light source or the third light source.

According to the tenth aspect of the present disclosure, it is possible to narrow the range in which the non-irradiation region is formed as compared with a case where the center line of the light emitted from the first light source intersects only the center line of the light emitted from one of the second light source and the third light source.

According to the thirteenth aspect of the present disclosure, it is possible to prevent excessive light from entering the light receiving unit as compared with a case where the light receiving unit receives the reflected light at the intersection portion where the center lines of the light beams intersect each other.

### BRIEF DESCRIPTION OF THE DRAWINGS

Exemplary embodiment(s) of the present invention will be described in detail based on the following figures, wherein:
Fig. 1 is a block diagram showing an example of a schematic configuration of a distance measurement apparatus to which the present exemplary embodiment is applied;
Fig. 2 is a diagram showing a light emitting unit according to the present exemplary embodiment and irradiation regions that are irradiated with light emitted from the light emitting unit;
Fig. 3 is a diagram describing a configuration of light sources and behavior of light beams emitted from the light sources;
Figs. 4A and 4B are diagrams describing a relationship between a light emitting chip and a lens;
Fig. 5 is a diagram describing a relationship between an irradiation region that is irradiated with light emitted from the light source of the light emitting unit and an irradiation region that is irradiated with light emitted from the light source;
Figs. 6A to 6C are views of an irradiation surface as viewed in a +z direction from a -z direction side;
Figs. 7A and 7B are diagrams describing a light emitting surface of the light source to which the present exemplary embodiment is applied;
Fig. 8 is a diagram showing an example of an irradiation surface that is irradiated with light beams emitted from the light source having the light emitting surface shown in Fig. 7A and the light source having the light emitting surface shown in Fig. 7B;
Figs. 9A and 9B are diagrams describing an order in which a control unit turns on light emitting sections of the light source and irradiates irradiation sections of the irradiation surface with light beams;
Figs. 10A and 10B are diagrams showing a relationship between light sources of a light emitting unit according to the present exemplary embodiment and irradiation regions that are irradiated with light beams emitted from the respective light sources;
Figs. 11A to 11D are diagrams describing a relationship between a light emitting chip and a lens included in the light sources;
Figs. 12A and 12B are diagrams showing a relationship between light sources of the light emitting unit according to the present exemplary embodiment and irradiation regions that are irradiated with light beams emitted from the respective light sources;
Fig. 13 is a diagram describing a relationship between a plurality of irradiation regions; and
Fig. 14 is a diagram describing a relationship between a plurality of irradiation regions.

### DETAILED DESCRIPTION OF THE INVENTION

Hereinafter, exemplary embodiments of the present invention will be described in detail with reference to the accompanying drawings.

The technical scope of the present invention is not limited to the scope to be described below as an exemplary embodiment. It is clear from the description of the claims that a combination of a plurality of examples and various modifications or improvements to the exemplary embodiment described above are also included in the technical scope of the present invention.

### [Exemplary Embodiment 1]

### (Distance Measurement Apparatus 1)

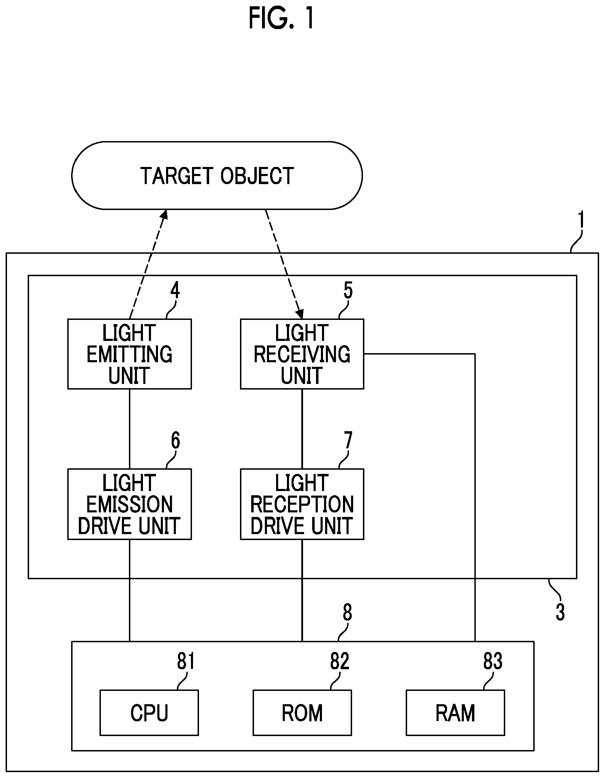

Fig. 1 is a block diagram showing an example of a schematic configuration of a distance measurement apparatus 1 to which the present exemplary embodiment is applied.

The distance measurement apparatus 1 measures a distance to a target object based on a time from a timing at which light is emitted from a light emitting unit 4 to a timing at which the light reflected by the target object is received by a light receiving unit 5. That is, the distance measurement apparatus 1 is an apparatus that performs distance measurement based on a ToF method. The ToF method includes an indirect ToF (iToF) method in which a time is measured from a difference between a phase of emitted light and a phase of received light, and a direct ToF (dToF) method in which a time from emission to reception of light is directly measured. In the present exemplary embodiment, description will be made assuming that the distance measurement apparatus 1 performs distance measurement based on the indirect ToF method.

As shown in Fig. 1, the distance measurement apparatus 1 includes an optical device 3 and a control unit 8.

The optical device 3 includes the light emitting unit 4 that emits light toward a predetermined range, the light receiving unit 5 that receives light reflected by the target object existing in an irradiation range of the light emitted from the light emitting unit 4, a light emission drive unit 6 that drives the light emitting unit 4, and a light reception drive unit 7 that drives the light receiving unit 5. The light emitting unit 4 is an example of a light emitting device. The light emission drive unit 6 is an example of a drive unit.

### (Control Unit 8)

The control unit 8 controls the operations of the light emitting unit 4 and the light receiving unit 5 of the optical device 3.

In addition, the control unit 8 acquires a result of the light reception by the light receiving unit 5, and measures a distance from the distance measurement apparatus 1 to the target object by the ToF method based on a result of the light reception.

The control unit 8 is an example of a distance measurement unit.

The control unit 8 is configured of a central processing unit (CPU) 81, a read only memory (ROM) 82, and a random access memory (RAM) 83.

The CPU 81 is an example of a processor, and implements each function, which will be described below, by loading various programs stored in the ROM 82 or the like into the RAM 83 and executing the programs. The RAM 83 is a memory used as a work memory or the like of the CPU 81. The ROM 82 is a memory that stores various programs and the like executed by the CPU 81.

Here, the program executed by the CPU 81 may be provided in a state of being stored in a computer-readable recording medium such as a magnetic recording medium (a magnetic tape, a magnetic disk, or the like), an optical recording medium (an optical disk or the like), a magneto-optical recording medium, or a semiconductor memory. In addition, the program executed by the CPU 81 may be provided by using a communication section such as the Internet.

In the embodiments above, the term "processor" refers to hardware in a broad sense. Examples of the processor include general processors (e.g., CPU: Central Processing Unit) and dedicated processors (e.g., GPU: Graphics Processing Unit, ASIC: Application Specific Integrated Circuit, FPGA: Field Programmable Gate Array, and programmable logic device). In the embodiments above, the term "processor" is broad enough to encompass one processor or plural processors in collaboration which are located physically apart from each other but may work cooperatively. The order of operations of the processor is not limited to one described in the embodiments above, and may be changed.

### (Light Emitting Unit 4)

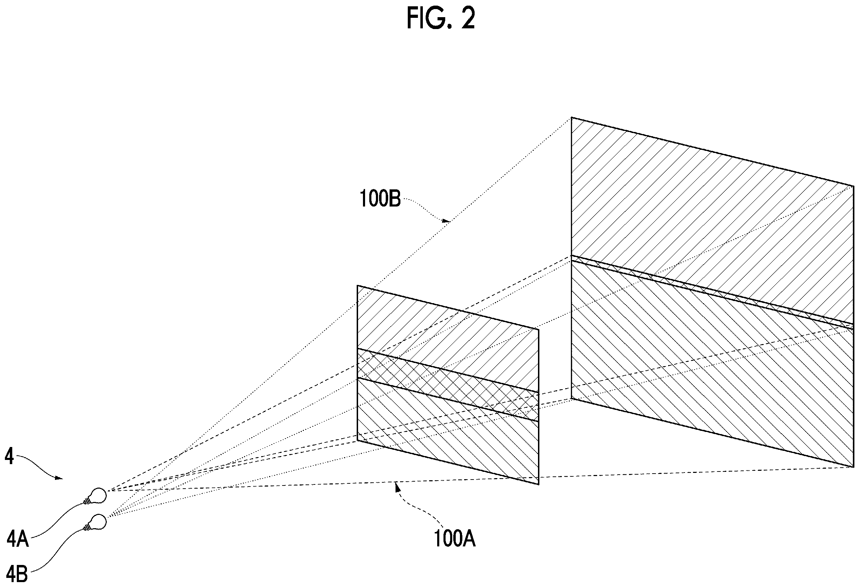

Fig. 2 is a diagram showing the light emitting unit 4 according to the present exemplary embodiment and irradiation regions 100A and 100B that is irradiated with light emitted from the light emitting unit 4.

The light emitting unit 4 has a plurality of (two in this example) light sources 4A and 4B that irradiate different irradiation regions 100A and 100B with light beams. In other words, the light emitting unit 4 has the light source 4A that irradiates the irradiation region 100A with light and the light source 4B that irradiates the irradiation region 100B different from the irradiation region 100A with light. Here, the irradiation region 100A is a region through which the light emitted from the light source 4A passes. Similarly, the irradiation region 100B is a region through which the light emitted from the light source 4B passes. The fact that the irradiation region 100A and the irradiation region 100B are different means that the irradiation region 100A and the irradiation region 100B do not coincide with each other, and the irradiation region 100A and the irradiation region 100B may have an overlapping portion.

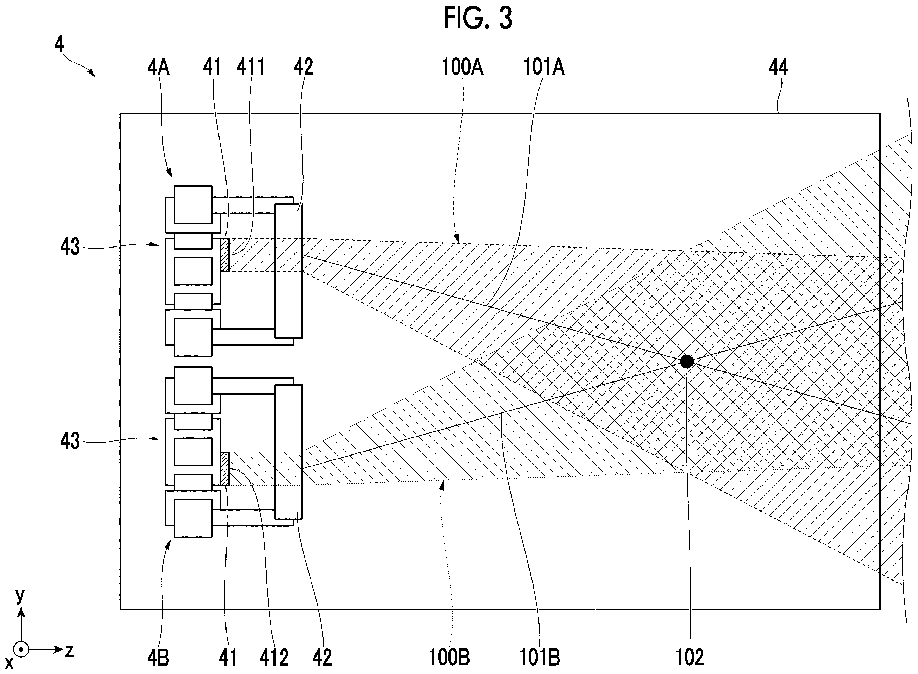

In addition, the light emitting unit 4 includes a housing 44 (see Fig. 3 described below) that accommodates the light sources 4A and 4B. The housing 44 has a box-like shape and accommodates the light sources 4A and 4B therein. Then, the housing 44 emits the light beams emitted from the light sources 4A and 4B to an outside in a predetermined range. A relationship between the housing 44 and the irradiation region 100A will be described in detail below.

Fig. 3 is a diagram describing a configuration of the light sources 4A and 4B and behavior of light beams emitted from the light sources 4A and 4B. In Fig. 3, a front side direction of a paper plane is defined as a +x direction, an upper direction of the paper plane is defined as a +y direction, and a right direction of the paper plane is defined as a z direction. Opposite directions of the directions are defined as a -x direction, a -y direction, and a -z direction, respectively.

As shown in Fig. 3, the light sources 4A and 4B are arranged in the y direction. In this example, the light source 4A is disposed on the +y direction side with respect to the light source 4B.

Each of the light sources 4A and 4B has a light emitting chip 41 which is an example of a light emitting unit that emits light in the +z direction. In addition, each of the light sources 4A and 4B has a lens 42 which is an example of an optical system that expands an irradiation range of the light emitted from the light emitting chip 41 as a distance from the light emitting chip 41 increases in the +z direction. In addition, each of the light sources 4A and 4B has a support member 43 that supports the light emitting chip 41 and the lens 42 such that the light emitting chip 41 is disposed at a predetermined relative position with respect to the lens 42.

The light source 4A and the light source 4B have the same configuration except for a relative position of the light emitting chip 41 with respect to the lens 42.

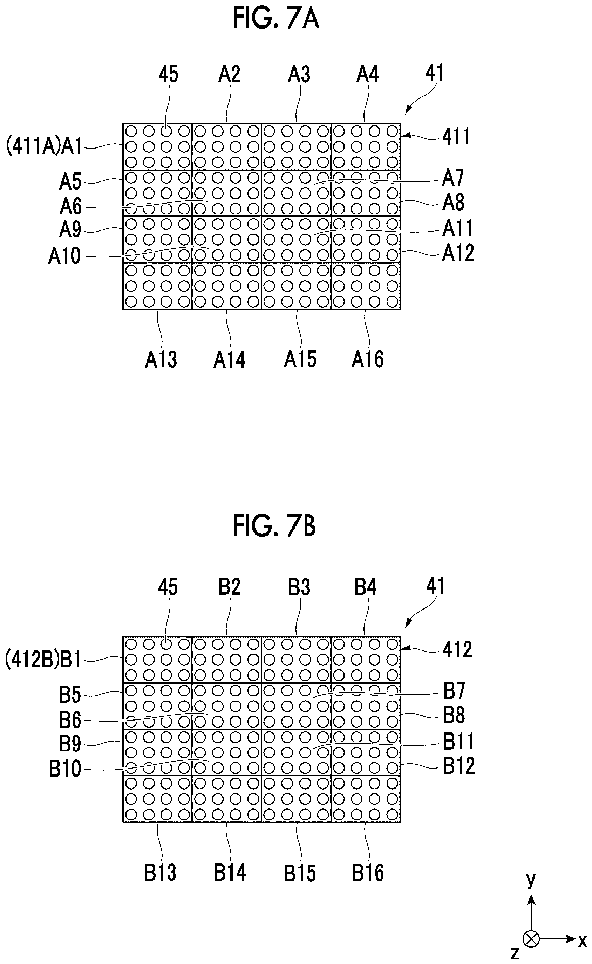

The light emitting chip 41 has a light emitting surface on which a plurality of vertical cavity surface emitting lasers (VCSELs) (referred to as VCSELs hereinafter, and shown by reference numeral 45 in Figs. 7A and 7B to be described below) are arranged. Hereinafter, the light emitting surface of the light emitting chip 41 included in the light source 4A will be referred to as a light emitting surface 411, and the light emitting surface of the light emitting chip 41 included in the light source 4B will be referred to as a light emitting surface 412.

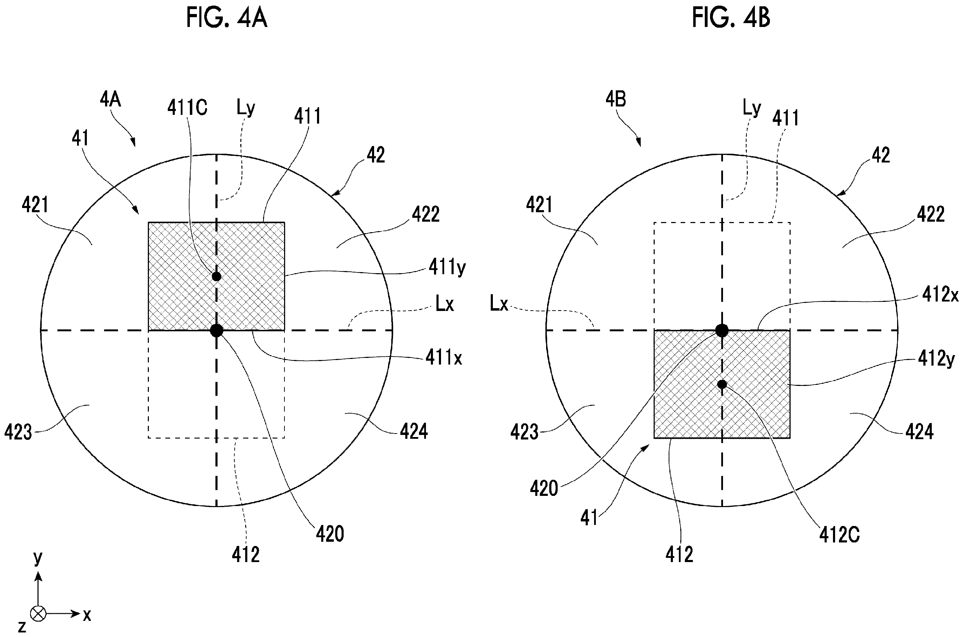

The light emitting chips 41 are disposed such that the light emitting surfaces 411 and 412 are located along an xy plane. In this example, as shown in Figs. 4A and 4B to be described below, the light emitting surfaces 411 and 412 have a rectangular shape having long sides 411x and 412x extending in the x direction and short sides 411y and 412y extending in the y direction.

The light emitting chips 41 emit light beams in the +z direction from the light emitting surfaces 411 and 412 by the light emission of the VCSEL.

Here, the respective light emitting chips 41 of the light sources 4A and 4B of the light emitting unit 4 according to the present exemplary embodiment are independently driven by the light emission drive unit 6 (see Fig. 1) to perform a light emission operation. It should be noted that the light sources 4A and 4B emit light by supplying power to the VCSEL included in the light sources 4A and 4B by the light emission drive unit 6.

Here, the phrase "independently driven" refers to a state in which light is emitted by driving each of the light sources 4A and 4B. The light emission drive unit 6 drives each light emitting chip 41 in response to a control signal from the control unit 8 (see Fig. 1). Therefore, the light emitting chip 41 of the light source 4A and the light emitting chip 41 of the light source 4B do not necessarily emit light simultaneously. For example, the light emitting chip 41 of the light source 4A can emit light while the light emitting chip 41 of the light source 4B does not emit light.

The lens 42 is provided on the +z direction side with respect to the light emitting chip 41. It should be noted that the lens 42 is provided on a downstream side of the light emitting chip 41 in a direction in which the light emitting chip 41 emits light. In addition, the lenses 42 are provided to face the light emitting surfaces 411 and 412 of the light emitting chips 41. As a result, the light beams emitted from the light emitting surfaces 411 and 412 of the light emitting chips 41 in the +z direction are incident into the lenses 42.

In addition, the lens 42 is disposed such that an optical axis 420 extends in the z direction. The lens 42 refracts the light emitted from the light emitting chip 41 in a direction intersecting the z direction, thereby expanding the irradiation range of the light in the +z direction.

Figs. 4A and 4B are diagrams describing a relationship between the light emitting chip 41 and the lens 42. Fig. 4A shows the light emitting chip 41 and the lens 42 in the light source 4A, and Fig. 4B shows the light emitting chip 41 and the lens 42 in the light source 4B. Figs. 4A and 4B correspond to views of the light emitting chip 41 and the lens 42 in the light sources 4A and 4B as viewed in the +z direction from the -z direction side.

In Figs. 4A and 4B, a straight line passing through the optical axis 420 of the lens 42 and extending in the x direction, and a straight line passing through the optical axis 420 of the lens 42 and extending in the y direction are shown by broken lines. Hereinafter, the straight line passing through the optical axis 420 of the lens 42 and extending in the x direction will be referred to as a first straight line Lx, and the straight line passing through the optical axis 420 of the lens 42 and extending in the y direction will be referred to as a second straight line Ly.

In addition, in the following description, four regions in which the lens 42 is divided by the first straight line Lx and the second straight line Ly will be referred to as a first region 421, a second region 422, a third region 423, and a fourth region 424, respectively. The first region 421 is a region of the lens 42 on the +y direction side with respect to the first straight line Lx and on the -x direction side with respect to the second straight line Ly. The second region 422 is a region of the lens 42 on the +y direction side with respect to the first straight line Lx and on the +x direction side with respect to the second straight line Ly. The third region 423 is a region of the lens 42 on the -y direction side with respect to the first straight line Lx and on the -x direction side with respect to the second straight line Ly. The fourth region 424 is a region of the lens 42 on the -y direction side with respect to the first straight line Lx and on the +x direction side with respect to the second straight line Ly.

The lens 42 has a circular shape with the optical axis 420 as the center in a case of being viewed along the z direction. The lens 42 has an axisymmetric optical property with the optical axis 420 as the center. More specifically, the lens 42 refracts the light incident along the +z direction in a direction approaching the optical axis 420. That is, the lens 42 refracts the light incident into the first region 421 in the +x direction and the -y direction. In addition, the lens 42 refracts the light incident into the second region 422 in the -x direction and the -y direction. In addition, the lens 42 refracts the light incident into the third region 423 in the +x direction and the +y direction. In addition, the lens 42 refracts the light incident into the fourth region 424 in the -x direction and the +y direction. Further, the lens 42 has an optical property of refracting incident light more larger as the incident light is directed from the optical axis 420 toward a circumference along a radial direction. The lens 42 does not refract light incident into the optical axis 420.

As described above, the light sources 4A and 4B have different positions of the light emitting chip 41 with respect to the lens 42.

As shown in Fig. 4A, in the light source 4A, the light emitting chip 41 and the lens 42 are disposed such that the light emitting surface 411 faces the first region 421 and the second region 422 of the lens 42.

Specifically, in the light source 4A, the light emitting chip 41 and the lens 42 are disposed such that a center 411C of the light emitting surface 411 is located to be shifted in the +y direction with respect to the optical axis 420 of the lens 42. In addition, in the light source 4A, the light emitting chip 41 and the lens 42 are disposed such that the center 411C of the light emitting surface 411 is located on the second straight line Ly of the lens 42. Further, in the light source 4A, the light emitting chip 41 and the lens 42 are disposed such that the long side 411x located on the -y direction side of the light emitting surface 411 overlaps the first straight line Lx of the lens 42.

In addition, in the light source 4B, the light emitting chip 41 and the lens 42 are disposed such that a position of the light emitting surface 412 with respect to the lens 42 is symmetrical to a position of the light emitting surface 411 with respect to the lens 42 in the light source 4A, with the first straight line Lx of the lens 42 as a symmetry axis.

That is, as shown in Fig. 4B, in the light source 4B, the light emitting chip 41 and the lens 42 are disposed such that the light emitting surface 412 faces the third region 423 and the fourth region 424 of the lens 42. Specifically, in the light source 4B, the light emitting chip 41 and the lens 42 are disposed such that a center 412C of the light emitting surface 412 is located to be shifted in the -y direction with respect to the optical axis 420 of the lens 42. In addition, in the light source 4B, the light emitting chip 41 and the lens 42 are disposed such that the center 412C of the light emitting surface 412 is located on the second straight line Ly of the lens 42. Further, in the light source 4B, the light emitting chip 41 and the lens 42 are disposed such that the long side 412x located on the +y direction side of the light emitting surface 412 overlaps the first straight line Lx of the lens 42.

In the light emitting unit 4 according to the present exemplary embodiment, the light emitting surface 411 of the light emitting chip 41 in the light source 4A and the light emitting surface 412 of the light emitting chip 41 in the light source 4B overlap the first straight lines Lx of each lens 42. As a result, there is no gap between the relative positions of the light emitting surface 411 and the light emitting surface 412 with respect to the lens 42.

In the light emitting unit 4 according to the present exemplary embodiment, the relative positions of the light emitting surface 411 and the light emitting surface 412 with respect to the lens 42 overlap only on the first straight line Lx of the lenses 42, but the present invention is not limited to this. For example, in the present exemplary embodiment, the light emitting surface 411 may be disposed by being shifted on the -y direction side with respect to Fig. 4A, and the light emitting surface 412 may be disposed on the +y direction side with respect to Fig. 4B, so that the relative positions of the light emitting surface 411 and the light emitting surface 412 with respect to the lens 42 may overlap in the first region 421 to the fourth region 424 of the lens 42.

### (Irradiation Region with Light from Light Emitting Unit 4)

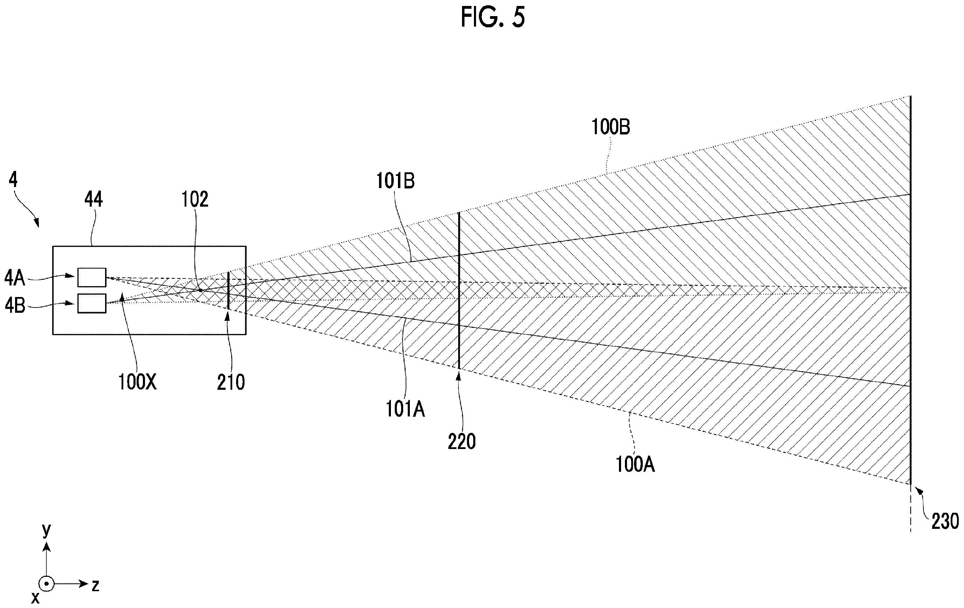

Fig. 5 is a diagram describing a relationship between an irradiation region 100A that is irradiated with the light emitted from the light source 4A of the light emitting unit 4 and an irradiation region 100B that is irradiated with the light emitted from the light source 4B. Fig. 5 is a view of the light emitting unit 4 and the irradiation regions 100A and 100B as viewed in the -x direction from the +x direction side.

Subsequently, the relationship between the irradiation region 100A that is irradiated with the light emitted from the light source 4A and the irradiation region 100B that is irradiated with the light emitted from the light source 4B will be described with reference to Fig. 5 and Figs. 2 to Figs. 4A and 4B described above.

In the light source 4A, the light emitted from the light emitting surface 411 of the light emitting chip 41 is incident onto the first straight line Lx of the lens 42 and into the first region 421 and the second region 422 on the +y direction side with respect to the first straight line Lx. In this example, the light emitted from the light emitting surface 411 is incident into the lens 42 along the +z direction.

Then, the light incident into the lens 42 from the light emitting surface 411 is refracted in the direction approaching the optical axis 420 by the optical property of the lens 42. Specifically, the light incident into the first region 421 of the lens 42 from the light emitting surface 411 is refracted in the +x direction and the -y direction. In addition, the light incident into the second region 422 of the lens 42 from the light emitting surface 411 is refracted in the -x direction and the -y direction. The light refracted by the lens 42 is emitted from the light source 4A.

In the light source 4B, the light emitted from the light emitting surface 412 of the light emitting chip 41 is incident onto the first straight line Lx of the lens 42 and into the third region 423 and the fourth region 424 on the -y direction side with respect to the first straight line Lx. In this example, the light emitted from the light emitting surface 412 is incident into the lens 42 in the +z direction.

Then, the light incident into the lens 42 from the light emitting surface 412 is refracted in the direction approaching the optical axis 420 by the optical property of the lens 42. Specifically, the light incident into the third region 423 of the lens 42 from the light emitting surface 412 is refracted in the +x direction and the +y direction. In addition, the light incident into the fourth region 424 of the lens 42 from the light emitting surface 412 is refracted in the - x direction and the +y direction. The light refracted by the lens 42 is emitted from the light source 4B.

As described above, the lens 42 has the optical property of refracting incident light more larger as the incident light is directed from the optical axis 420 toward a circumference along a radial direction.

As a result, the irradiation region 100A that is irradiated with the light emitted from the light source 4A is expanded in the ±x direction and the -y direction as it goes in the +z direction. A center line 101A of the irradiation region 100A is inclined toward the -y direction as it goes in the +z direction.

In addition, the irradiation region 100B that is irradiated with the light emitted from the light source 4B is expanded in the ±x direction and the +y direction as it goes in the +z direction. A center line 101B of the irradiation region 100B is inclined toward the +y direction as it goes in the +z direction.

In the light emitting unit 4 according to the present exemplary embodiment, as shown in Figs. 3 and 5, the center line 101A of the light emitted from the light source 4A to the irradiation region 100A and the center line 101B of the light emitted from the light source 4B to the irradiation region 100B intersect each other.

Here, in the present exemplary embodiment, the intersection of the center line 101A of the irradiation region 100A and the center line 101B of the irradiation region 100B means that the irradiation region 100A and the irradiation region 100B have a point at which the center line 101A and the center line 101B intersect each other in a case where the irradiation region 100A and the irradiation region 100B are viewed along one direction (the x direction in this example) intersecting the z direction. Hereinafter, the point at which the center line 101A and the center line 101B intersect will be referred to as an intersection portion 102.

In addition, the center line 101A of the irradiation region 100A is a line connecting centers of irradiation surfaces which are irradiated with the light beams from the light source 4A among irradiation surfaces which are irradiated with the light beams emitted from the light emitting unit 4. Similarly, the center line 101B of the irradiation region 100B is a line connecting centers of irradiation surfaces which are irradiated with the light beams from the light source 4B among irradiation surfaces which are irradiated with the light beams emitted from the light emitting unit 4.

In the present exemplary embodiment, the irradiation region 100A and the irradiation region 100B are arranged in the -y direction on the -z direction side with respect to the intersection portion 102. In addition, on the +z direction side with respect to the intersection portion 102, the irradiation region 100A and the irradiation region 100B are arranged in the +y direction. It should be noted that the arrangement of the irradiation region 100A and the irradiation region 100B is reversed between the -z direction side and the +z direction side with respect to the intersection portion 102. It should be further noted that, on the +z direction side with respect to the intersection portion 102, the arrangement of the irradiation region 100 A and the irradiation region 100B is reversed from the arrangement of the light source 4A and the light source 4B.

In the light emitting unit 4 according to the present exemplary embodiment, the intersection portion 102 is located inside the housing 44. The reason for this will be described in detail below.

In addition, in the present exemplary embodiment, a non-irradiation region 100X, which is not irradiated with the light beams emitted from the light source 4A and the light source 4B, is formed between the irradiation region 100A and the irradiation region 100B on the -z direction side with respect to the intersection portion 102. In this example, as shown in Fig. 5, the non-irradiation region 100X is formed in a range from the light sources 4A and 4B to a certain distance on the -z direction side with respect to the intersection portion 102.

In a case where different irradiation regions are irradiated with light beams using a plurality of light sources as in the light emitting unit 4 according to the present exemplary embodiment, a non-irradiation region, which is not irradiated with light, may be formed between the irradiation regions that are irradiated with light beams from the respective light sources. In addition, the non-irradiation region may be formed in a wide range in the +z direction from the light sources, depending on a positional relationship between the plurality of light sources, a direction of the light emitted from each light source, and the like. For example, in a case where the different irradiation regions are irradiated with light beams using the plurality of light sources such that the center lines of the irradiation regions do not intersect each other, the non-irradiation region is likely to be formed in a wide range in the +z direction from the light sources. In the non-irradiation region, the target object is not irradiated with the light from the light source, so that it is not possible to measure the distance to the target object based on the light reflected by the target object.

On the other hand, in the light emitting unit 4 according to the present exemplary embodiment, the light sources 4A and 4B emit light beams such that the center line 101A of the irradiation region 100A and the center line 101B of the irradiation region 100B intersect each other, so that the non-irradiation region 100X is not formed on the +z direction side with respect to the intersection portion 102. As a result, in the light emitting unit 4 according to the present exemplary embodiment, the range in which the non-irradiation region 100X is formed may be narrowed as compared with a case where the light beams are emitted using the plurality of light sources such that the center lines of the irradiation regions do not intersect each other.

In addition, in the light emitting unit 4 according to the present exemplary embodiment, the non-irradiation region 100X is located inside the housing 44. As a result, the target object, which is a target of the distance measurement, is prevented from entering the non-irradiation region 100X in which the distance to the target object cannot be measured.

The irradiation surface is a surface on which light from the light emitting unit 4 orthogonal to the z direction is emitted at a certain distance in the z direction of the irradiation regions 100A and 100B that are irradiated with the light beams emitted from the light sources 4A and 4B of the light emitting unit 4.

Fig. 5 shows irradiation surfaces 210, 220, and 230 arranged in an order in a direction away from the light sources 4A and 4B of the light emitting unit 4 in the +z direction, as the irradiation surfaces. The irradiation surfaces 210, 220, and 230 extend in the x direction and the y direction at a certain distance in the +z direction. In addition, the irradiation surfaces 210, 220, and 230 are located on the +z direction side with respect to the intersection portion 102 where the center line 101A of the irradiation region 100A and the center line 101B of the irradiation region 100B intersect each other. Further, the irradiation surface 210 is located inside the housing 44, and the irradiation surfaces 220 and 230 are located outside the housing 44.

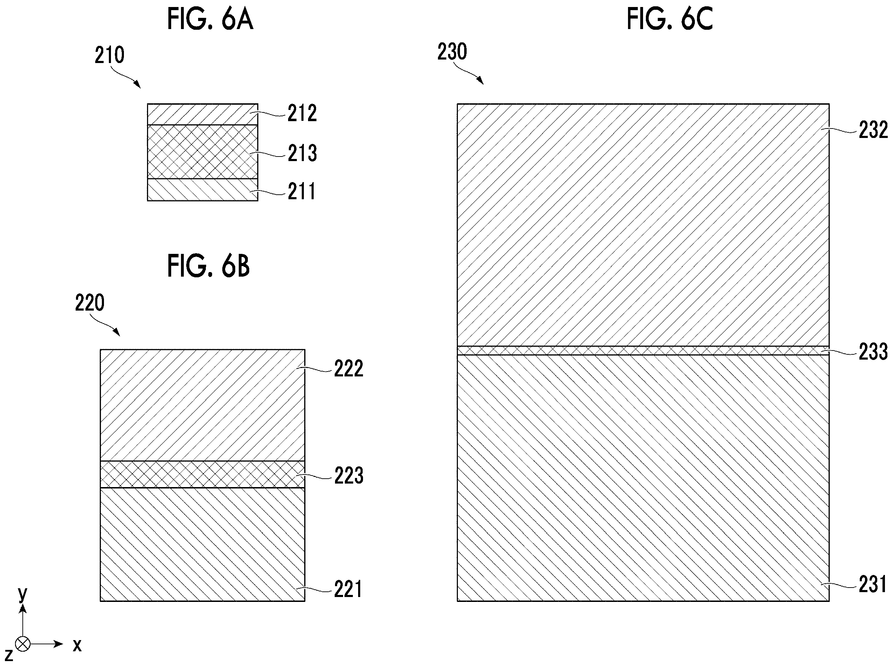

Figs. 6A to 6C are views of the irradiation surfaces 210, 220, and 230 as viewed in the +z direction from the -z direction side.

In the light sources 4A and 4B (see Fig. 3) according to the present exemplary embodiment, as described above, the irradiation range of the light emitted from the light emitting chip 41 is expanded in the +z direction by the lens 42. Therefore, the area of each irradiation surface increases in the order of the irradiation surface 210, the irradiation surface 220, and the irradiation surface 230 arranged in the +z direction.

The irradiation surface 210 includes an irradiation surface 211 that is irradiated with the light from the light source 4A and an irradiation surface 212 that is irradiated with the light from the light source 4B. In the irradiation surface 210, the irradiation surface 211 and the irradiation surface 212 are arranged in the y direction. In this example, the irradiation surface 211 is located on the -y direction side with respect to the irradiation surface 212. That is, the arrangement of the light sources 4A and 4B in the light emitting unit 4 and the arrangement of the irradiation surfaces 211 and 212 on the irradiation surface 210 are reversed.

In addition, on the irradiation surface 210, an overlapping region 213 in which partial regions of the irradiation surface 211 and the irradiation surface 212 in the y direction overlap each other is formed. It should be noted that, on the irradiation surface 210, an overlapping region 213 in which a partial region on the +y direction side in the irradiation surface 211 and a partial region on the -y direction side in the irradiation surface 212 overlap each other is formed.

Similarly, the irradiation surface 220 includes an irradiation surface 221 that is irradiated with the light from the light source 4A and an irradiation surface 222 that is irradiated with the light from the light source 4B. In the irradiation surface 220, the irradiation surface 221 and the irradiation surface 222 are arranged in the y direction. In this example, the irradiation surface 221 is located on the -y direction side with respect to the irradiation surface 222. That is, the arrangement of the light sources 4A and 4B in the light emitting unit 4 and the arrangement of the irradiation surfaces 221 and 222 on the irradiation surface 220 are reversed.

In addition, on the irradiation surface 220, an overlapping region 223 in which partial regions of the irradiation surface 221 and the irradiation surface 222 in the y direction overlap each other is formed. It should be noted that, on the irradiation surface 220, an overlapping region 223 in which a partial region on the +y direction side in the irradiation surface 221 and a partial region on the -y direction side in the irradiation surface 222 overlap each other is formed.

Similarly, the irradiation surface 230 includes an irradiation surface 231 that is irradiated with the light from the light source 4A and an irradiation surface 232 that is irradiated with the light from the light source 4B. On the irradiation surface 230, the irradiation surface 231 and the irradiation surface 232 are arranged in the y direction. In this example, the irradiation surface 231 is located on the -y direction side with respect to the irradiation surface 232. That is, the arrangement of the light sources 4A and 4B in the light emitting unit 4 and the arrangement of the irradiation surfaces 231 and 232 on the irradiation surface 230 are reversed.

In addition, on the irradiation surface 230, an overlapping region 233 in which partial regions of the irradiation surface 231 and the irradiation surface 232 in the y direction overlap each other is formed. It should be noted that, on the irradiation surface 230, an overlapping region 233 in which a partial region on the +y direction side in the irradiation surface 231 and a partial region on the -y direction side in the irradiation surface 232 overlap each other is formed.

In the irradiation surfaces 210, 220, and 230, the overlap between the irradiation surfaces 211, 221, and 231 that are irradiated with the light from the light source A and the irradiation surfaces 212, 222, and 232 that are irradiated with the light from the light source 4B is reduced as the distance from the light sources 4A and 4B increases in the +z direction. In addition, although not shown, the irradiation surface that is irradiated with the light from the light source 4A and the irradiation surface that is irradiated with the light from the light source 4B are not formed with the overlapping region at a certain distance away from the light sources 4A and 4B in the +z direction.

As a result, a ratio of the area of the overlapping region 213, 223, and 233 to the area of the irradiation surfaces 210, 220, and 230 is reduced as the distance from the light sources 4A and 4B increases. Specifically, the ratio of the area of the overlapping region 223 to the area of the irradiation surface 220 is smaller than the ratio of the area of the overlapping region 213 to the area of the irradiation surface 210. In addition, the ratio of the area of the overlapping region 233 to the area of the irradiation surface 230 is smaller than the ratio of the area of the overlapping region 223 to the area of the irradiation surface 220.

In addition, in the irradiation surface 210, the area of the overlapping region 213 is larger than a sum of the area of the irradiation surface 211 excluding the overlapping region 213 and the area of the irradiation surface 212 excluding the overlapping region 213.

On the other hand, in the irradiation surface 220, the area of the overlapping region 223 is smaller than a sum of the area of the irradiation surface 221 excluding the overlapping region 223 and the area of the irradiation surface 222 excluding the overlapping region 223.

Similarly, in the irradiation surface 230, the area of the overlapping region 233 is smaller than a sum of the area of the irradiation surface 231 excluding the overlapping region 233 and the area of the irradiation surface 232 excluding the overlapping region 233.

As described above, on the irradiation surface located on the +z direction side with respect to the intersection portion 102, the closer to the intersection portion 102, the higher the ratio of the area of the overlapping region to the area of the irradiation surface. In a case where the light source 4A and the light source 4B are simultaneously turned on, in the overlapping region, the light from the light source 4A and the light from the light source 4B are emitted, so that the amount of emitted light is larger than that in a region other than the overlapping region.

In a case where the target object enters the overlapping region which is close to the intersection portion 102, the amount of light emitted to the target object may be excessive. In this case, the amount of light received by a light receiving element, which will be described below, of the light receiving unit 5 that receives the light reflected by the target object may be excessive, resulting in signal saturation. In this case, it becomes difficult to measure the distance to the target object. In addition, in a case where the target object is a human, an eye safety problem may occur because of an excessive amount of irradiated light.

On the other hand, in the light emitting unit 4 according to the present exemplary embodiment, the intersection portion 102 is located inside the housing 44.

As a result, the target object is prevented from entering the overlapping region which is close to the intersection portion 102. In the examples shown in Figs. 3 and 5, the target object is prevented from entering the overlapping region 213 of the irradiation surfaces 210 which is close to the intersection portion 102. As a result, the amount of light emitted to the target object is prevented from being excessive.

### (Light Receiving Unit 5)

The light receiving unit 5 includes a light receiving surface that extends in the x direction and the y direction and in which a plurality of light receiving elements are arranged. Then, the light receiving unit 5 receives the light emitted from the light emitting unit 4 and reflected by the target object, by each light receiving element.

The light receiving surface is divided into a plurality of light receiving sections corresponding to the plurality of light sources 4A and 4B of the light emitting unit 4. In the light receiving unit 5 according to the present exemplary embodiment, the light receiving surface is divided into two light receiving sections in the y direction. Each light receiving section has a plurality of light receiving elements that are regularly arranged. Each light receiving element receives the light emitted from the light sources 4A and 4B of the light emitting unit 4 and reflected by the target object, and outputs an electrical signal in response to the received light. Examples of the light receiving element include a photodiode or a phototransistor.

Each light receiving element of the light receiving unit 5 according to the present exemplary embodiment receives the light reflected by the target object at a position farther from the light emitting unit 4 than the intersection portion 102 where the center line 101A of the irradiation region 100A and the center line 101B of the irradiation region 100B intersect each other.

Each light receiving section is independently driven by the light reception drive unit 7 (see Fig. 1) to perform a light receiving operation. The drive of the light receiving section refers to changing the light receiving element included in the light receiving section from a state in which it cannot receive light to a state in which it can receive light and output an electrical signal. In addition, the phrase "independently driven" refers to driving each light receiving section into a state in which it can receive light and output an electrical signal. The light reception drive unit 7 drives each light receiving section in response to a control signal from the control unit 8 (see Fig. 1).

In addition, in a case where the light receiving element included in each light receiving section receives light, the light receiving element outputs an electrical signal corresponding to the received light to the control unit 8.

### [Exemplary Embodiment 2]

In the light emitting unit 4, the light emitting surface 411 of the light emitting chip 41 included in the light source 4A and the light emitting surface 412 of the light emitting chip 41 included in the light source 4B may be divided into a plurality of light emitting sections. Hereinafter, as Exemplary Embodiment 2 of the present invention, an aspect in which the light emitting surfaces 411 and 412 are divided into a plurality of light emitting sections will be described. The same reference numerals are used for the same configurations as in Exemplary Embodiment 1 described above, and the detailed description thereof will be omitted here.

### (Light Emitting Surfaces 411 and 412)

Figs. 7A and 7B are diagrams describing the light emitting surface 411 of the light source 4A to which the present exemplary embodiment is applied and the light emitting surface 412 of the light source 4B to which the present exemplary embodiment is applied. Fig. 7A shows the light emitting surface 411 of the light emitting chip 41 included in the light source 4A, and Fig. 7B shows the light emitting surface 412 of the light emitting chip 41 included in the light source 4B. Figs. 7A and 7B correspond to views of the light emitting surfaces 411 and 412 as viewed in the +z direction from the -z direction side.

The light emitting surface 411 of the light source 4Ain Fig. 7A is divided into a plurality of light emitting sections 411A each including at least one VCSEL 45. In this example, the light emitting surface 411 is divided into a total of 16 light emitting sections 411A arranged in four rows in the x direction and four rows in the y direction, as an example. As shown in the figure, in a case where it is necessary to distinguish the light emitting sections 411A from each other, the respective light emitting sections 411A are distinguished as light emitting sections A1 to A16 in order from the upper left side (the end in the -x direction and the +y direction) in Fig. 7A.

In the present specification, the term "to" indicates a plurality of components distinguished individually by numbers, and means that components before and after "to" and components having numbers between the components are included. For example, the light emitting sections A1 to A16 include 16 light emitting sections 411A from the light emitting section A1 to the light emitting section A16 in numerical order.

The light emitting surface 412 of the light source 4B in Fig. 7B is divided into a plurality of light emitting sections 412B each including at least one VCSEL 45. In this example, the light emitting surface 412 is divided into a total of 16 light emitting sections 412B arranged in four rows in the x direction and four rows in the y direction, as an example. As shown in the figure, in a case where it is necessary to distinguish the light emitting sections 412B from each other, the respective light emitting sections 412B are distinguished as light emitting sections B1 to B16 in order from the upper left side (the end in the -x direction and the +y direction) in Fig. 7B.

Each light emitting section 411A of the light source 4A and each light emitting section 412B of the light source 4B are independently driven by the light emission drive unit 6 (see Fig. 1) to perform a light emission operation.

The light emission drive unit 6 drives each light emitting section 411A of the light source 4A and each light emitting section 412B of the light source 4B in response to a control signal from the control unit 8 (see Fig. 1). Therefore, the light emitting sections 411A of the light source 4A do not necessarily emit light simultaneously, and for example, in the example of Fig. 7A, a state can be taken in which the light emitting section A1 emits light but the light emitting section A16 does not emit light. Similarly, the light emitting sections 412B of the light source 4B do not necessarily emit light simultaneously, and for example, in the example of Fig. 7B, a state can be taken in which the light emitting section B1 emits light but the light emitting section B16 does not emit light.

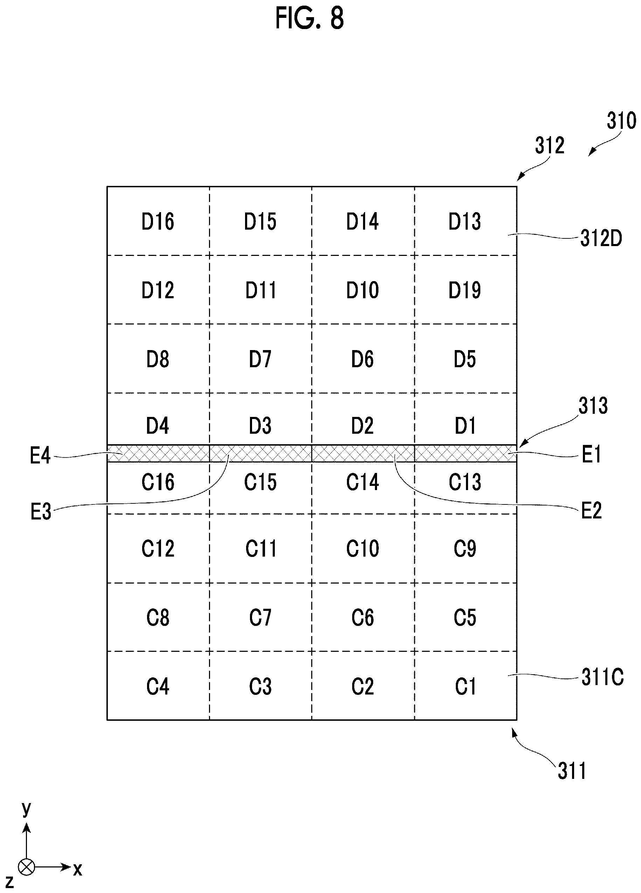

Fig. 8 is a diagram showing an example of an irradiation surface 310 that is irradiated with the light beams emitted from the light source 4A having the light emitting surface 411 shown in Fig. 7A and the light source 4B having the light emitting surface 412 shown in Fig. 7B. It should be noted that Fig. 8 is a view of the irradiation surface 310 as viewed in the +z direction. Fig. 8 shows the irradiation surface 310 such that a distance in the z direction from the light sources 4A and 4B is the same as the distance in the z direction from the light sources 4A and 4B to the irradiation surface 230 shown in Fig. 5.

The irradiation surface 310 includes an irradiation surface 311 that is irradiated with the light from the light source 4A, and an irradiation surface 312 that is irradiated with the light from the light source 4B. On the irradiation surface 310, the irradiation surface 311 and the irradiation surface 312 are arranged in the y direction. In addition, on the irradiation surface 310, an overlapping region 313 in which a partial region on the +y direction side in the irradiation surface 311 and a partial region on the -y direction side in the irradiation surface 312 overlap each other is formed.

The irradiation surface 311 is divided into a plurality of irradiation sections 311C corresponding to the light emitting sections 411A on the light emitting surface 411. In the example of Fig. 8, the irradiation surface 311 is divided into a total of 16 irradiation sections 311C arranged in four rows in the x direction and four rows in the y direction. In a case where it is necessary to distinguish the irradiation sections 311C of the irradiation surface 311 from each other, the respective irradiation sections 311C are denoted by C1 to C16. In this example, light emitted from a certain light emitting section Ai is emitted to an irradiation section Ci to which the same number i is assigned. In the following description, the light emitting section Ai to which the same number is assigned for a certain irradiation section Ci may be referred to as "corresponding light emitting section". On the contrary, the irradiation section Ci to which the same number i is assigned for a certain light emitting section Ai may be referred to as "corresponding irradiation section". The same applies to the irradiation surface 312 to be described below.

The light emitted from each of the light emitting sections A1 to A16 of the light emitting surface 411 is refracted by the lens 42 (see Fig. 3) and is emitted to the irradiation surface 311. As a result, on the irradiation surface 311, the irradiation sections C1 to C16 are arranged in the order from the lower right side (the end in the +x direction and the -y direction) in Fig. 8. It should be noted that the order in which the irradiation sections C1 to C16 are arranged on the irradiation surface 311 is reversed in the x direction and the y direction with respect to the order in which the light emitting sections A1 to A16 are arranged on the light emitting surface 411.

Similarly, the irradiation surface 312 is divided into a plurality of irradiation sections 312D corresponding to the light emitting sections 412B on the light emitting surface 412. In the example of Fig. 8, the irradiation surface 312 is divided into a total of 16 irradiation sections 312D arranged in four rows in the x direction and four rows in the y direction. In a case where it is necessary to distinguish the irradiation sections 312D from each other, the respective irradiation sections 312D are denoted by D1 to D16.

The light emitted from each of the light emitting sections B1 to B16 of the light emitting surface 412 is refracted by the lens 42 and is emitted to the irradiation surface 312. As a result, on the irradiation surface 312, the irradiation sections D1 to D16 are arranged in the order from the lower right side (the end in the +x direction and the -y direction) in Fig. 8. It should be noted that the order in which the irradiation sections D1 to D16 are arranged on the irradiation surface 312 is reversed in the x direction and the y direction with respect to the order in which the light emitting sections B1 to B16 are arranged on the light emitting surface 412.

In the irradiation surface 310, the irradiation section C13 of the irradiation surface 311 and the irradiation section D1 of the irradiation surface 312 are adjacent to each other in the y direction. In addition, the irradiation section C14 of the irradiation surface 311 and the irradiation section D2 of the irradiation surface 312 are adjacent to each other in the y direction. In addition, the irradiation section C15 of the irradiation surface 311 and the irradiation section D3 of the irradiation surface 312 are adjacent to each other in the y direction. In addition, the irradiation section C16 of the irradiation surface 311 and the irradiation section D4 of the irradiation surface 312 are adjacent to each other in the y direction.

As described above, the overlapping region 313 is formed on the irradiation surface 310.

The overlapping region 313 includes an overlapping portion E1 in which a partial region on the +y direction side of the irradiation section C13 of the irradiation surface 311 and a partial region on the -y direction side of the irradiation section D1 of the irradiation surface 312 overlap each other. In addition, the overlapping region 313 includes an overlapping portion E2 in which a partial region on the +y direction side of the irradiation section C14 of the irradiation surface 311 and a partial region on the -y direction side of the irradiation section D2 of the irradiation surface 312 overlap each other. In addition, the overlapping region 313 includes an overlapping portion E3 in which a partial region on the +y direction side of the irradiation section C15 of the irradiation surface 311 and a partial region on the -y direction side of the irradiation section D3 of the irradiation surface 312 overlap each other. In addition, the overlapping region 313 includes an overlapping portion E4 in which a partial region on the +y direction side of the irradiation section C16 of the irradiation surface 311 and a partial region on the -y direction side of the irradiation section D4 of the irradiation surface 312 overlap each other. The overlapping portions E1 to E4 are arranged in the -x direction.

### (Light Receiving Unit 5)

The light receiving unit 5 includes a light receiving surface that extends in the x direction and the y direction and in which a plurality of light receiving elements are arranged, as in Exemplary Embodiment 1 described above.

The light receiving surface is divided into a plurality of light receiving sections corresponding to the irradiation sections C1 to C16 of the irradiation surface 311 that is irradiated with the light beams from the light emitting sections A1 to A16 of the light source 4A and the irradiation sections D1 to D16 of the irradiation surface 312 that is irradiated with the light beams from the light emitting sections B1 to B16 of the light source 4B. That is, the light receiving surface includes 16 light receiving sections arranged in four rows in the x direction and four rows in the y direction corresponding to the irradiation sections C1 to C16, and 16 light receiving sections arranged in four rows in the x direction and four rows in the y direction corresponding to the irradiation sections D1 to D16.

Each light receiving section receives light emitted from the light sources 4A and 4B of the light emitting unit 4 and reflected by the target object existing in the corresponding irradiation section of the irradiation surface 311 and the irradiation surface 312. Each light receiving section of the light receiving unit 5 is independently driven by the light reception drive unit 7 (see Fig. 1) to perform a light receiving operation.

### (Operation of Light Emitting Unit 4)

Subsequently, an operation of the light emitting unit 4 driven by the light emission drive unit 6 under the control of the control unit 8 will be described.

In the light emitting unit 4, in a case where the light emitting section of the light source 4A and the light emitting section of the light source 4B, which irradiate the overlapping region 313 with light beams, are simultaneously turned on, the overlapping region 313 is irradiated with the light from the light emitting section of the light source 4A and the light from the light emitting section of the light source 4B. In this case, the amount of light emitted to the overlapping region 313 is larger than that in a region other than the overlapping region of the irradiation surface 310. As a result, the amount of light emitted to the irradiation surface 310 is non-uniform in the overlapping region 313 and the region other than the overlapping region 313.

On the other hand, the control unit 8 of the present exemplary embodiment does not simultaneously turn on the light emitting section of the light source 4A and the light emitting section of the light source 4B, which irradiate the irradiation sections that form the overlapping region 313 with light beams. In other words, the control unit 8 does not simultaneously turn on in the light emitting section of the light source 4A and the light emitting section of the light source 4B, which irradiate the irradiation sections adjacent to each other in the irradiation surface 311 and the irradiation surface 312 with light beams.

More specifically, the control unit 8 does not simultaneously turn on the light emitting section A13 of the light source 4A that irradiates the irradiation section C13 that forms the overlapping portion E1 of the overlapping region 313 with light and the light emitting section B1 of the light source 4B that irradiates the irradiation section D1 that forms the overlapping portion E1 with light.

In addition, the control unit 8 does not simultaneously turn on the light emitting section A14 of the light source 4A that irradiates the irradiation section C14 that forms the overlapping portion E2 of the overlapping region 313 with light and the light emitting section B2 of the light source 4B that irradiates the irradiation section D2 that forms the overlapping portion E2 with light.

In addition, the control unit 8 does not simultaneously turn on the light emitting section A15 of the light source 4A that irradiates the irradiation section C15 that forms the overlapping portion E3 of the overlapping region 313 with light and the light emitting section B3 of the light source 4B that irradiates the irradiation section D3 that forms the overlapping portion E3 with light.

In addition, the control unit 8 does not simultaneously turn on the light emitting section A16 of the light source 4A that irradiates the irradiation section C16 that forms the overlapping portion E4 of the overlapping region 313 with light and the light emitting section B4 of the light source 4B that irradiates the irradiation section D4 that forms the overlapping portion E4 with light.

The control unit 8 according to the present exemplary embodiment turns on all the light emitting sections A1 to A16 of the light source 4A and all the light emitting sections B1 to B16 of the light source 4B while preventing the light emitting section of the light source 4A and the light emitting section of the light source 4B, which irradiate the irradiation sections that form the overlapping region 313 with light beams, from being simultaneously turned on. It should be noted that the control unit 8 turns on all the light emitting sections A1 to A16 of the light source 4A and all the light emitting sections B1 to B16 of the light source 4B by turning on, with a temporal shift, the light emitting section of the light source 4A and the light emitting section of the light source 4B, which irradiate the irradiation sections that form the overlapping region 313 with light beams. As a result, all the irradiation sections C1 to C16 of the irradiation surface 311 and all the irradiation sections D1 to D16 of the irradiation surface 312 are irradiated with light beams, and the entire irradiation surface 310 is irradiated with light without any defect.

Here, in a case where the aspect is adopted in which the light emitting section of the light source 4A and the light emitting section of the light source 4B, which irradiate the irradiation sections that form the overlapping region 313 with light beams, are prevented from being simultaneously turned on, an order in which the light emitting sections A1 to A16 of the light source 4A and the light emitting sections B1 to B16 of the light source 4B are turned on is not limited.

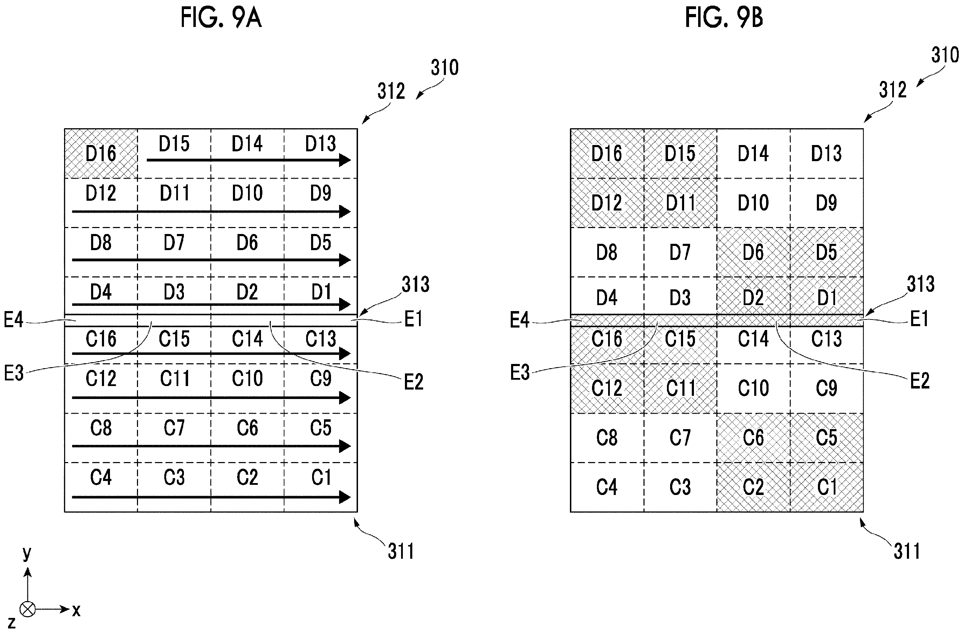

Figs. 9A and 9B are diagrams describing an order in which the control unit 8 turns on the light emitting sections A1 to A16 of the light source 4A and the light emitting sections B1 to B16 of the light source 4B and irradiates the irradiation sections C1 to C16 and the irradiation sections D1 to D16 of the irradiation surface 310 with light beams. Figs. 9A and 9B are views of the irradiation surface 310 as viewed in the +z direction, as in Fig. 8. In Figs. 9A and 9B, the hatched irradiation section is an irradiation section that is irradiated with light from the light emitting section that is turned on by the control unit 8.

The control unit 8 may sequentially turn on the light emitting sections A1 to A16 of the light source 4A and the light emitting sections B1 to B16 of the light source 4B one by one. In this example, the control unit 8 turns on the light emitting sections B1 to B16 of the light source 4B, and then turns on the light emitting sections A1 to A16 of the light source 4A. It should be noted that, in this example, the light emitting sections A1 to A16 of the light source 4A and the light emitting sections B1 to B16 of the light source 4B are not simultaneously turned on.

Specifically, as shown in Fig. 9A, the control unit 8 sequentially turns on the light emitting section B16 to the light emitting section B1 of the light source 4B such that the light is sequentially emitted from the irradiation section D16 located at the upper left of the irradiation surface 312 to the irradiation section D1 located at the lower right. Subsequently, the control unit 8 sequentially turns on the light emitting section A16 to the light emitting section A1 of the light source 4A such that the light is sequentially emitted from the irradiation section C16 located at the upper left of the irradiation surface 311 to the irradiation section C1 located at the lower right.

As a result, all the irradiation sections C1 to C16 and D1 to D16 of the irradiation surface 310 are irradiated with light.

In addition, in a case where the control unit 8 does not simultaneously turn on the light emitting section of the light source 4A and the light emitting section of the light source 4B, which irradiate the irradiation sections that form the overlapping region 313 with light beams, any light emitting section of the light source 4A and any light emitting section of the light source 4B may be simultaneously turned on.

In the example shown in Fig. 9B, the control unit 8 turns on the light emitting section B1 of the light source 4B that irradiates the overlapping portion E1 of the overlapping region 313 with light, and does not turn on the light emitting section A13 of the light source 4A that irradiates the overlapping portion E1 with light. In addition, the control unit 8 turns on the light emitting section B2 of the light source 4B that irradiates the overlapping portion E2 of the overlapping region 313 with light, and does not turn on the light emitting section A14 of the light source 4A that irradiates the overlapping portion E2 with light.

Further, the control unit 8 turns on the light emitting section A15 of the light source 4A that irradiates the overlapping portion E3 of the overlapping region 313 with light, and does not turn on the light emitting section B3 of the light source 4B that irradiates the overlapping portion E3 with light. In addition, the control unit 8 turns on the light emitting section A16 of the light source 4A that irradiates the overlapping portion E4 of the overlapping region 313 with light, and does not turn on the light emitting section B4 of the light source 4B that irradiates the overlapping portion E4 with light.

In this example, the irradiation sections C15 and C16 where the light emitting sections A15 and A16 of the light source 4A are turned on and the light is applied, and the irradiation sections D1 and D2 where the light emitting sections B1 and B2 of the light source 4B are turned on and the light is applied are examples of a first irradiation section.

In addition, the irradiation sections C13 and C14 where the light emitting sections A13 and A14 of the light source 4A are not turned on and the light is not applied, and the irradiation sections D3 and D4 where the light emitting sections B3 and B4 of the light source 4B are not turned on and the light is not applied are examples of a second irradiation section.

In the example shown in Fig. 9B, the control unit 8 simultaneously turns on the light emitting sections of the light source 4A, which irradiate the irradiation sections that do not form the overlapping region 313 of the irradiation surface 311 with light beams, and the light emitting sections of the light source 4B, which irradiate the irradiation sections that do not form the overlapping region 313 of the irradiation surface 312 with light beams. More specifically, the control unit 8 simultaneously turns on the light emitting sections A1, A2, A5, A6, A11, and A12 of the light source 4A, which irradiate the irradiation sections C1, C2, C5, C6, C11, and C12 of the irradiation surface 311 with light beams. In addition, the control unit 8 simultaneously turns on the light emitting sections B5, B6, B11, B12, B15, and B16 of the light source 4B, which irradiate the irradiation sections D5, D6, D11, D12, D15, and D16 of the irradiation surface 312 with light beams.

After the control unit 8 simultaneously turns on the light emitting sections A1, A2, A5, A6, A11, A12, A15, and A16 of the light source 4A and the light emitting sections B1, B2, B5, B6, B11, B12, B15, and B16 of the light source 4B, the control unit 8 turns off these light emitting sections. Then, the remaining light emitting sections A3, A4, A7 to A10, A13, and A14 of the light source 4A and the remaining light emitting sections B3, B4, B7 to B10, B13, and B14 of the light source 4B are simultaneously turned on.

As a result, all the irradiation sections C1 to C16 and D1 to D16 of the irradiation surface 310 are irradiated with light.

As described above, in the present exemplary embodiment, in a case where the light emitting section of one light source that irradiates the first irradiation section forming the overlapping region 313 of the irradiation surface 310 with light is turned on, and the light emitting section of the other light source that irradiates the second irradiation section forming the overlapping region 313 with light is not turned on, the light emitting sections that irradiate, with light beams, the irradiation sections other than the first irradiation section and the second irradiation section are turned on. As a result, a time required to irradiate all the irradiation sections of the irradiation surface 310 with light beams may be shortened, as compared with a case where, for example, the light emitting sections that irradiate, with light beams, the irradiation sections other than the first irradiation section and the second irradiation section are not simultaneously turned on.

### [Exemplary Embodiment 3]

In Exemplary Embodiment 1 and Exemplary Embodiment 2 described above, a case where the light emitting unit 4 has two light sources 4A and 4B as the plurality of light sources has been described as an example. However, the light emitting unit 4 may have three or more light sources as the plurality of light sources. Hereinafter, as Exemplary Embodiment 3 of the present invention, an aspect in which the light emitting unit 4 has four light sources 4K, 4L, 4M, and 4N will be described. The same reference numerals are used for the same configurations as in Exemplary Embodiment 1 and Exemplary Embodiment 2 described above, and the detailed description thereof will be omitted here.

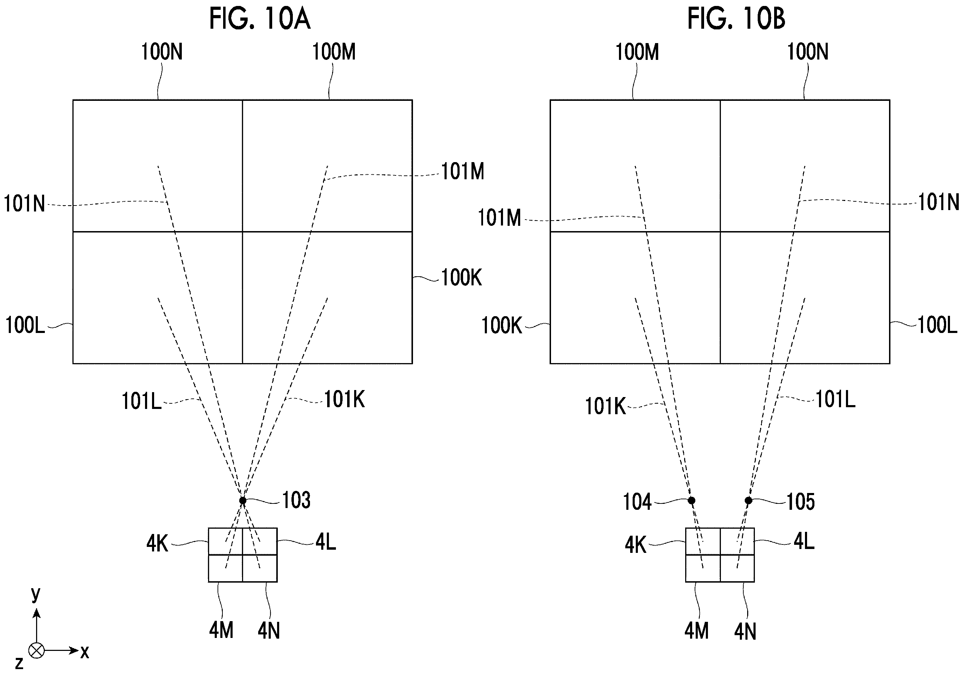

Figs. 10A and 10B are diagrams showing a relationship between the light sources 4K to 4N of the light emitting unit 4 according to the present exemplary embodiment and irradiation regions 100K to 100N that are irradiated with light beams emitted from the respective light sources 4K to 4N. Figs. 10A and 10B show cross sections of the irradiation regions 100K to 100N cut along a plane orthogonal to the z direction at a certain distance in the z direction as the irradiation regions 100K to 100N. Figs. 10A and 10B correspond to views of the light sources 4K to 4N and the irradiation regions 100K to 100N as viewed in the +z direction side from the -z direction side. In Figs. 10A and 10B, the light sources 4K to 4N and the irradiation regions 100K to 100N are shown to be shifted in an up-down direction (y direction) of the paper plane, but in reality, the light sources 4K to 4N and the irradiation regions 100K to 100N are disposed to face each other in the z direction. In Figs. 10A and 10B, the light sources 4K to 4N are located in the front side direction (-z direction) of the paper plane, and the irradiation regions 100K to 100N are located in a back side direction (+z direction) of the paper plane.

Details will be described below, but in Figs. 10A and 10B, a relationship between the arrangement of the light sources 4K to 4N and the arrangement of the irradiation regions 100K to 100N is different.

The light emitting unit 4 according to the present exemplary embodiment has a light source 4K that irradiates the irradiation region 100K with light, a light source 4L that irradiates the irradiation region 100L with light, a light source 4M that irradiates the irradiation region 100M with light, and a light source 4N that irradiates the irradiation region 100N with light.

In the light emitting unit 4, the light sources 4K to 4N are arranged in order from the upper left side (the end in the -x direction and the +y direction) to the lower right side (the end in the +x direction and the -y direction) in Fig. 10A and Fig. 10B. That is, in the light emitting unit 4, the light source 4K is disposed at the end in the -x direction and the +y direction, and the light source 4L is disposed at the end in the +x direction and the +y direction so as to be adjacent to the light source 4K in the +x direction. In addition, in the light emitting unit 4, the light source 4M is disposed at the end in the -x direction and the -y direction so as to be adjacent to the light source 4K in the -y direction, and the light source 4N is disposed at the end in the +x direction and -y direction so as to be adjacent to the light source 4M in the +x direction.

In this example, in a case where the light source 4K is used as a first light source, the light source 4L arranged in the +x direction, which is an example of a first direction, with respect to the light source 4K is an example of a second light source. In addition, the light source 4M arranged in the -y direction, which is an example of a second direction, with respect to the light source 4K is an example of a third light source.

In Fig. 10A, the irradiation regions 100N, 100M, 100L, and 100K are arranged in order from the upper left side (the end in the -x direction and the +y direction) to the lower right side (the end in the +x direction and the -y direction).

In addition, in Fig. 10A, a center line 101K of the light emitted from the light source 4K to the irradiation region 100K, a center line 101L of the light emitted from the light source 4L to the irradiation region 100L, a center line 101M of the light emitted from the light source 4M to the irradiation region 100M, and a center line 101N of the light emitted from the light source 4N to the irradiation region 100N intersect each other at one intersection portion 103. It should be noted that, in Fig. 10A, the center line 101K, the center line 101L, the center line 101M, and the center line 101N intersect each other in both the x direction and the y direction.

In addition, in Fig. 10A, the arrangement of the irradiation regions 100K to 100N is reversed in the x direction and the y direction with respect to the arrangement of the light sources 4K to 4N on the +z direction side with respect to the intersection portion 103.

In Fig. 10B, the irradiation regions 100M, 100N, 100K, and 100L are arranged in order from the upper left side (the end in the -x direction and the +y direction) to the lower right side (the end in the +x direction and the -y direction).

In addition, in Fig. 10B, the center line 101K of the irradiation region 100K and the center line 101M of the irradiation region 100M, which are irradiated with the light beams from the light source 4K and the light source 4M arranged in the y direction, intersect at an intersection portion 104. In addition, the center line 101L of the irradiation region 100L and the center line 101N of the irradiation region 100N, which are irradiated with the light beams from the light source 4L and the light source 4N arranged in the y direction, intersect at an intersection portion 105.

On the other hand, the center line 101K of the irradiation region 100K and the center line 101L of the irradiation region 100L, which are irradiated with the light beams from the light source 4K and the light source 4L arranged in the x direction, do not intersect each other. Similarly, the center line 101M of the irradiation region 100M and the center line 101N of the irradiation region 100N, which are irradiated with the light beams from the light source 4M and the light source 4N arranged in the x direction, do not intersect each other.

In addition, in Fig. 10B, the arrangement of the irradiation regions 100K and 100M is reversed in the y direction with respect to the arrangement of the light sources 4K and 4M on the +z direction side with respect to the intersection portion 104. Similarly, the arrangement of the irradiation regions 100L and 100N is reversed in the y direction with respect to the arrangement of the light sources 4L and 4N on the +z direction side with respect to the intersection portion 105.

As described above, in a case where the light emitting unit 4 has three or more light sources, as long as center lines of the irradiation regions irradiated with light beams from at least two light sources selected from the plurality of light sources intersect each other, a combination of the light sources in which the center lines of the irradiation regions do not intersect each other may be included.

In the light emitting unit 4, the center lines of the irradiation regions irradiated with light beams from at least two light sources selected from the plurality of light sources intersect each other, so that the range in which the non-irradiation region, which is not irradiated with light from the light source, is formed may be narrowed as compared with a case where none of the center lines of the irradiation regions irradiated with light beams from the plurality of light sources intersect each other.

In a case where the light emitting unit 4 has a plurality of light sources of three or more, from the viewpoint of further narrowing the range in which the non-irradiation region is formed, for example, it is preferable that the center lines of the irradiation regions irradiated with light beams from the plurality of light sources intersect each other at one intersection portion.

For example, in the example shown in Fig. 10B, the range in which the non-irradiation region which is not irradiated with light beams from the light source 4K and the light source 4M is formed may be narrowed between the irradiation region 100K and the irradiation region 100M where the center line 101K and the center line 101M intersect each other. In addition, the range in which the non-irradiation region which is not irradiated with light beams from the light source 4L and the light source 4N is formed may be narrowed between the irradiation region 100L and the irradiation region 100N where the center line 101L and the center line 101N intersect each other.

On the other hand, the range in which the non-irradiation region which is not irradiated with light beams from the light source 4K and the light source 4L is formed is likely to be widened between the irradiation region 100K and the irradiation region 100L where the center line 101K and the center line 101L do not intersect each other. Similarly, the range in which the non-irradiation region which is not irradiated with light beams from the light source 4M and the light source 4N is formed is likely to be widened between the irradiation region 100M and the irradiation region 100N where the center line 101M and the center line 101N do not intersect each other.

On the other hand, as shown in Fig. 10A, in a case where all the center lines 101K, 101L, 101M, and 101N intersect each other at one intersection portion 103, the range in which the non-irradiation region which is not irradiated with the light beams from the light sources 4K to 4N is formed may be narrowed between the irradiation region 100K and the irradiation region 100M, between the irradiation region 100L and the irradiation region 100N, between the irradiation region 100K and the irradiation region 100L, and between the irradiation region 100M and the irradiation region 100N.

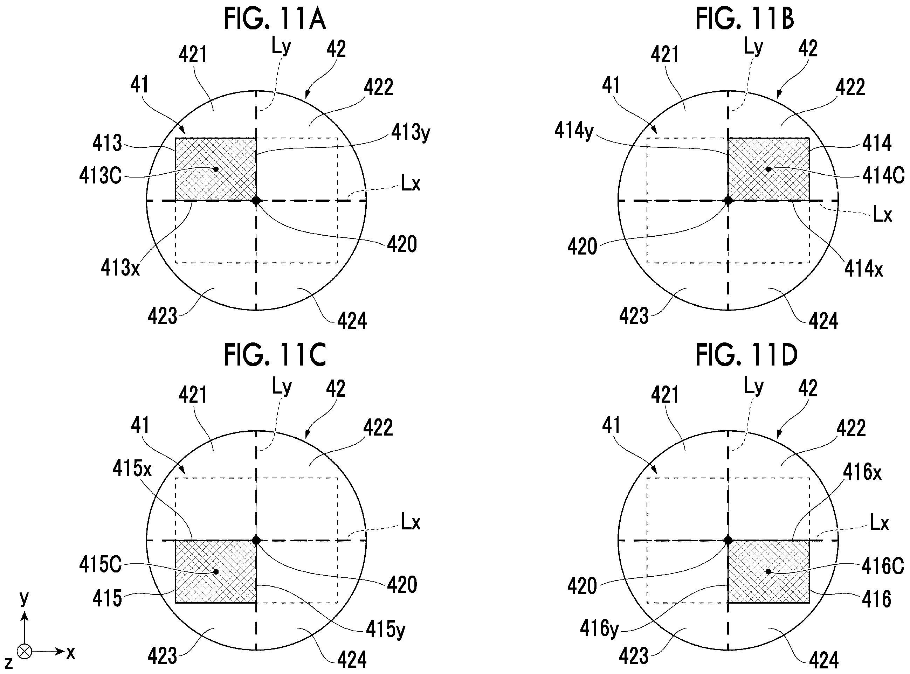

Figs. 11A to 11D are diagrams describing a relationship between the light emitting chip 41 and the lens 42 included in the light sources 4K to 4N. Figs. 11A to 11D show the relationship between the light emitting chip 41 and the lens 42 of each of the light sources 4K to 4N in a case where the light sources 4K to 4N emit light as shown in Fig. 10A. Fig. 11A shows the light emitting chip 41 and the lens 42 of the light source 4K, Fig. 11B shows the light emitting chip 41 and the lens 42 of the light source 4L, Fig. 11C shows the light emitting chip 41 and the lens 42 of the light source 4M, and Fig. 11D shows the light emitting chip 41 and the lens 42 of the light source 4N. Figs. 11A to 11D correspond to views of the light emitting chip 41 and the lens 42 in each of the light sources 4K to 4N as viewed in the +z direction from the -z direction side.

Hereinafter, the light emitting surfaces of the light emitting chip 41 included in the light sources 4K, 4L, 4M, and 4N will be referred to as light emitting surfaces 413, 414, 415, and 416, respectively.

As shown in Fig. 11A, in the light source 4K, the light emitting chip 41 and the lens 42 are disposed such that the light emitting surface 413 of the light emitting chip 41 faces the first region 421 of the lens 42.

Specifically, in the light source 4K, the light emitting chip 41 and the lens 42 are disposed such that a center 413C of the light emitting surface 413 is located to be shifted in the -x direction and the +y direction with respect to the optical axis 420 of the lens 42. In addition, in the light source 4K, the light emitting chip 41 and the lens 42 are disposed such that a long side 413x located on the -y direction side overlaps the first straight line Lx of the lens 42 and a short side 413y located on the +x direction side overlaps the second straight line Ly of the lens 42 on the light emitting surface 413.

In addition, in the light source 4L, the light emitting chip 41 and the lens 42 are disposed such that a center 414C of the light emitting surface 414 is located to be shifted in the +x direction and the +y direction with respect to the optical axis 420 of the lens 42. In addition, in the light source 4L, the light emitting chip 41 and the lens 42 are disposed such that a long side 414x located on the -y direction side overlaps the first straight line Lx of the lens 42 and a short side 414y located on the -x direction side overlaps the second straight line Ly of the lens 42 on the light emitting surface 414.

In addition, in the light source 4M, the light emitting chip 41 and the lens 42 are disposed such that a center 415C of the light emitting surface 415 is located to be shifted in the -x direction and the -y direction with respect to the optical axis 420 of the lens 42. In addition, in the light source 4M, the light emitting chip 41 and the lens 42 are disposed such that a long side 415x located on the +y direction side overlaps the first straight line Lx of the lens 42 and a short side 415y located on the +x direction side overlaps the second straight line Ly of the lens 42 on the light emitting surface 415.

In addition, in the light source 4N, the light emitting chip 41 and the lens 42 are disposed such that a center 416C of the light emitting surface 416 is located to be shifted in the +x direction and the -y direction with respect to the optical axis 420 of the lens 42. In addition, in the light source 4N, the light emitting chip 41 and the lens 42 are disposed such that a long side 416x located on the +y direction side overlaps the first straight line Lx of the lens 42 and a short side 416y located on the -x direction side overlaps the second straight line Ly of the lens 42 on the light emitting surface 416.

As described above, in the light emitting unit 4 according to the present exemplary embodiment, the light emitting surface 413 of the light emitting chip 41 in the light source 4K, the light emitting surface 414 of the light emitting chip 41 in the light source 4L, the light emitting surface 415 of the light emitting chip 41 in the light source 4M, and the light emitting surface 416 of the light emitting chip 41 in the light source 4N overlap the first straight line Lx and the second straight line Ly of the lens 42. It should be noted that there is no gap between the relative positions of the light emitting surfaces 413, 414, 415, and 416 with respect to the lens 42.

As a result, the non-irradiation region which is not irradiated with the light beams from the light sources 4K to 4L is prevented from being formed between the irradiation regions 100K, 100L, 100M, and 100N on the +z direction side with respect to the intersection portion 103 where the center lines 101K, 101L, 101M, and 101N intersect each other.

### [Exemplary Embodiment 4]

Subsequently, as Exemplary Embodiment 4 of the present invention, an aspect in which the light emitting unit 4 has three light sources 4P, 4Q, and 4R will be described. The same reference numerals are used for the same configurations as in Exemplary Embodiment 1 to Exemplary Embodiment 3 described above, and the detailed description thereof will be omitted here.

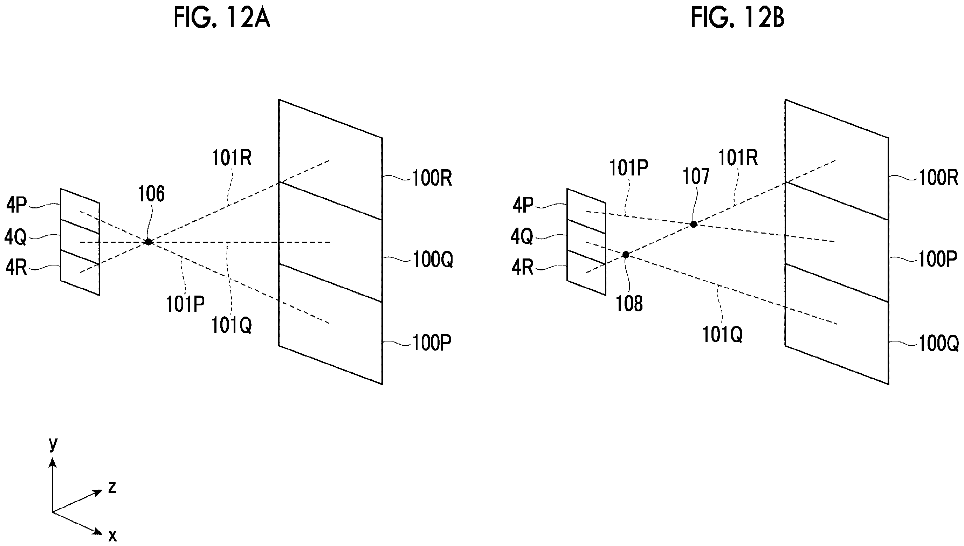

Figs. 12A and 12B are diagrams showing a relationship between the light sources 4P to 4R of the light emitting unit 4 according to the present exemplary embodiment and irradiation regions 100P to 100R that are irradiated with light beams emitted from the respective light sources 4P to 4R. Details will be described below, but in Figs. 12A and 12B, a relationship between the arrangement of the light sources 4P to 4R and the arrangement of the irradiation regions 100P to 100R is different.

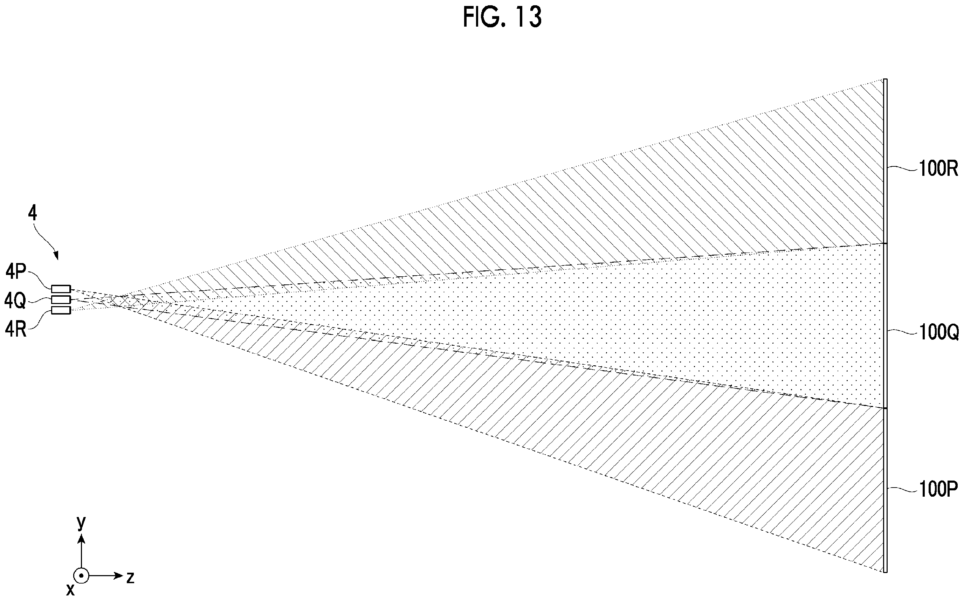

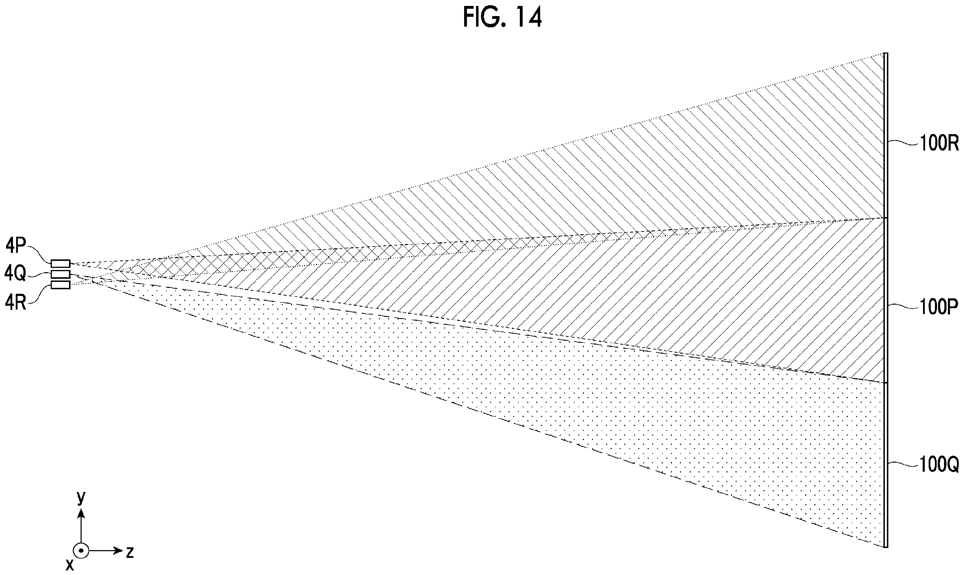

In addition, Figs. 13 and 14 are diagrams showing a relationship between the irradiation region 100P, the irradiation region 100Q, and the irradiation region 100R. Figs. 13 and 14 are views of the light sources 4P to 4R and the irradiation regions 100P to 100R as viewed in the - x direction from the +x direction side. Fig. 13 corresponds to the irradiation regions 100P and 100Q shown in Fig. 12A, and Fig. 14 corresponds to the irradiation regions 100P and 100Q shown in Fig. 12B.

The light emitting unit 4 according to the present exemplary embodiment has a light source 4P that irradiates the irradiation region 100P with light, a light source 4Q that irradiates the irradiation region 100Q with light, and a light source 4R that irradiates the irradiation region 100R with light.

In the light emitting unit 4, the light sources 4P, 4Q, and 4R are arranged in order from the +y direction side to the -y direction. That is, the light source 4P is disposed on the +y direction side with respect to the light source 4Q, and the light source 4Q is disposed on the +y direction side with respect to the light source 4R.

In Figs. 12A and 13, the irradiation region 100R, the irradiation region 100Q, and the irradiation region 100P are arranged in order from the +y direction side to the -y direction (from the top to the bottom of Fig. 13).

In addition, as shown in Figs. 12A and 12B, a center line 101P of the light emitted from the light source 4P to the irradiation region 100P, a center line 101Q of the light emitted from the light source 4Q to the irradiation region 100Q, and a center line 101R of the light emitted from the light source 4R to the irradiation region 100R intersect each other at one intersection portion 106. In this example, in a case where the light source 4P is an example of a first light source, the light sources 4Q and 4R are examples of a plurality of second light sources. In addition, in a case where the light source 4Q is an example of a first light source, the light sources 4P and 4R are examples of a plurality of second light sources. In addition, in a case where the light source 4R is an example of a first light source, the light sources 4P and 4Q are examples of a plurality of second light sources.

Further, in Figs. 12A and Fig. 13, the arrangement of the irradiation region 100P and the irradiation region 100Q is reversed in the y direction with respect to the arrangement of the light source 4P and the light source 4Q on the +z direction side with respect to the intersection portion 106. In addition, the arrangement of the irradiation regions 100P and 100R is reversed in the y direction with respect to the arrangement of the light sources 4P and 4R on the +z direction side with respect to the intersection portion 106. In addition, the arrangement of the irradiation regions 100Q and 100R is reversed in the y direction with respect to the arrangement of the light sources 4Q and 4R on the +z direction side with respect to the intersection portion 106.

As shown in Fig. 12A, the center line 101P, the center line 101Q, and the center line 101R intersect each other at one intersection portion 106, so that the non-irradiation region which is not irradiated with the light beams from the light sources 4P to 4R is not formed between the irradiation region 100P and the irradiation region 100Q and between the irradiation region 100Q and the irradiation region 100R, on the +z direction side with respect to the intersection portion 106.

As a result, the range in which the non-irradiation region which is not irradiated with the light beams from the light sources 4P and 4Q is formed may be narrowed as compared with a case where none of the center lines 101P to 101R of the irradiation regions 100P to 100R that are irradiated with the light beams from the three light sources 4P to 4Q intersect each other.

In Figs. 12B and 14, the irradiation region 100R, the irradiation region 100P, and the irradiation region 100Q are arranged in order from the +y direction side to the -y direction (from the top to the bottom of Fig. 14).

In addition, as shown in Figs. 12B, the center line 101P of the light emitted from the light source 4P to the irradiation region 100P and the center line 101R of the light emitted from the light source 4R to the irradiation region 100R intersect each other at an intersection portion 107. In addition, the center line 101Q of the light emitted from the light source 4Q to the irradiation region 100Q and the center line 101R of the light emitted from the light source 4R to the irradiation region 100R intersect each other at an intersection portion 108. It should be noted that the center line 101R of the light emitted from the light source 4R to the irradiation region 100R intersects both the center line 101P of the light emitted from the light source 4P to the irradiation region 100P and the center line 101Q of the light emitted from the light source 4Q to the irradiation region 100Q. In this example, the light source 4R is an example of a first light source, and the light sources 4P and 4Q are examples of a plurality of second light sources.

On the other hand, as shown in Figs. 12B, the center line 101P of the light emitted from the light source 4P to the irradiation region 100P and the center line 101Q of the light emitted from the light source 4Q to the irradiation region 100Q do not intersect each other.

Further, in Figs. 12B and Fig. 14, the arrangement of the irradiation region 100P and the irradiation region 100R is reversed in the y direction with respect to the arrangement of the light source 4P and the light source 4R on the +z direction side with respect to the intersection portion 107. Similarly, the arrangement of the irradiation regions 100Q and 100R is reversed in the y direction with respect to the arrangement of the light sources 4Q and 4R on the +z direction side with respect to the intersection portion 108.

In Fig. 12B and Fig. 14, the arrangement of the irradiation region 100P and the irradiation region 100Q is not reversed with respect to the arrangement of the light source 4P and the light source 4Q.

As shown in Fig. 12B, the center line 101P and the center line 101R intersect each other at one intersection portion 107, so that the non-irradiation region which is not irradiated with the light beams from the light sources 4P to 4R is not formed between the irradiation region 100P and the irradiation region 100R, on the +z direction side with respect to the intersection portion 107.

As a result, the range in which the non-irradiation region which is not irradiated with the light beams from the light sources 4P and 4Q is formed may be narrowed as compared with a case where none of the center lines 101P to 101R of the irradiation regions 100P to 100R that are irradiated with the light beams from the three light sources 4P to 4Q intersect each other.

As in Exemplary Embodiment 3, in a case where the light emitting unit 4 has three light sources 4P to 4R, from the viewpoint of further narrowing the range in which the non-irradiation region is formed, for example, it is preferable that the center lines 101P to 101R of the irradiation regions 100P to 100R intersect each other at one intersection portion 106.

For example, in the example of Fig. 12B and Fig. 14, the center line 101P of the irradiation region 100P and the center line 101R of the irradiation region 100R intersect each other at the intersection portion 107, so that the range in which the non-irradiation region which is not irradiated with the light beams from the light sources 4P and 4R is formed may be narrowed between the irradiation region 100P and the irradiation region 100R. On the other hand, in the example of Fig. 12B and Fig. 14, the range in which the non-irradiation region which is not irradiated with light beams from the light source 4P and the light source 4Q is formed is likely to be widened between the irradiation region 100P and the irradiation region 100Q where the center line 101P and the center line 101Q do not intersect each other.

On the other hand, in the example of Fig. 12A and Fig. 13, all the center lines 101P, 101Q, and 101R intersect each other at one intersection portion 106, so that the range in which the non-irradiation region which is not irradiated with the light beams from the light sources 4P to 4R is formed may be narrowed between the irradiation region 100P and the irradiation region 100Q and between the irradiation region 100Q and the irradiation region 100R.

Here, the light sources 4K to 4N of Exemplary Embodiment 3 and the light sources 4P to 4R of Exemplary Embodiment 4 may be configured such that the light emitting surface of each light emitting chip 41 is divided into a plurality of light emitting sections, as with the light sources 4A and 4B of Exemplary Embodiment 2. In this case, as in Exemplary Embodiment 2, for example, it is preferable that the control unit 8 controls the light emission operation of each light emitting section such that the light beams are not simultaneously emitted to the plurality of irradiation sections forming the overlapping region on the irradiation surface that is irradiated with the light from the light source. It should be noted that, for example, it is preferable that the control unit 8 does not simultaneously turn on the plurality of light emitting sections that irradiate the irradiation sections forming the overlapping region with light beams.

As a result, the amount of light emitted to the target object in the overlapping region is prevented from being excessive.

In the above-described exemplary embodiments, the housing 44 of the light emitting unit 4 is illustrated as an example of a housing that accommodates a plurality of light sources of the light emitting unit 4, but the present invention is not limited to this. The housing that accommodates a plurality of light sources may be a housing of the optical device 3 that accommodates the light receiving unit 5, the light emission drive unit 6, and the light reception drive unit 7 in addition to the plurality of light sources. In addition, the housing that accommodates a plurality of light sources may be a housing of the distance measurement apparatus 1 that accommodates the control unit 8 in addition to the plurality of light sources, the light receiving unit 5, the light emission drive unit 6, and the light reception drive unit 7. In addition, in the housing that accommodates the plurality of light sources, the plurality of light sources need not be completely covered with a cover or the like, and the housing may have a gap or an opening as long as the housing has a structure to prevent the entry of the target object.

In the optical device 3 or the distance measurement apparatus 1, as described above, the intersection portion where the center lines of the light beams emitted from the plurality of light sources to the irradiation regions intersect each other need only be located inside the housings. As a result, the entry of the target object into the periphery of the center line where the amount of light emitted to the target object is likely to be excessive is prevented.

In addition, in the above-described exemplary embodiments, in the light emitting unit 4, the lens 42 that refracts the light emitted from the light emitting chip 41 has been described as an example of the optical system, but the optical system is not limited to the lens 42 as long as the optical system changes the traveling direction of the light emitted from the light emitting chip 41 to expand the irradiation range of the light. As the optical system, for example, a diffractive optical element (DOE) that changes an angle of incident light and emits the light may be used.

In addition, various modifications and alternative configurations are involved in the present invention without departing from the technical scope of the present invention.

### (Supplementary Note)

(((1))) A light emitting device comprising:
   a light emitting unit that emits light;
   an optical system that expands an irradiation range of the light emitted from the light emitting unit as a distance from the light emitting unit increases; and
   a plurality of light sources each having the light emitting unit and the optical system and irradiating different irradiation regions with light beams, in which center lines of the light beams emitted from the light sources to the irradiation regions intersect each other.
(((2))) The light emitting device according to (((1))), further comprising:
   a housing that accommodates the plurality of light sources,
   wherein an intersection portion where the center lines of the light beams emitted from the plurality of light sources to the irradiation regions intersect each other is located inside the housing.
(((3))) The light emitting device according to (((1))) or (((2))),
   wherein the light emitting unit of each of the light sources includes a plurality of light emitting sections that irradiate, with light beams, a plurality of irradiation sections into which an irradiation region is divided,
   the light emitting device further comprises a drive unit that drives the light emitting unit of each of the light sources to individually turn on the plurality of light emitting sections of the light emitting unit, and
   the drive unit does not simultaneously turn on the light emitting sections that irradiate, with light beams, the irradiation sections adjacent to each other in the different irradiation regions.
(((4))) The light emitting device according to (((3))),
   wherein, in the irradiation sections where the light beams emitted from the light sources to the irradiation regions overlap, the drive unit turns on a light emitting section of one light source that irradiates a first irradiation section, which is one of the irradiation sections, with light, does not turn on a light emitting section of the other light source that irradiates a second irradiation section, which is the other of the irradiation sections, with light, and turns on light emitting sections that irradiate, with light beams, irradiation sections other than the first irradiation section and the second irradiation section.
(((5))) The light emitting device according to (((3))),
   wherein the drive unit turns on the light emitting sections that irradiate, with light beams, the irradiation sections adjacent to each other in the different irradiation regions, with a temporal shift.
(((6))) The light emitting device according to any one of (((1))) to (((5))),
   wherein optical systems and light emitting units of the plurality of light sources have the same characteristics, and
   the plurality of light sources have different relative positions of the optical system and the light emitting unit so that there is no gap between the different irradiation regions in a case where a distance from the plurality of light sources is a predetermined reference distance.
(((7))) The light emitting device according to any one of (((1))) to (((6))),
   wherein the plurality of light sources include a first light source, and a plurality of second light sources that are arranged in a first direction intersecting an optical axis of the optical system with respect to the first light source, and
   a center line of light emitted from the first light source intersects any of center lines of light beams emitted from the plurality of second light sources.
(((8))) The light emitting device according to (((7))),
   wherein positions of intersection portions where the center line of the light emitted from the first light source and the center lines of the light beams emitted from the respective second light sources intersect each other are coincident.
(((9))) The light emitting device according to any one of (((1))) to (((6))),
   wherein the plurality of light sources include a first light source, a second light source that is arranged in a first direction intersecting an optical axis of the optical system with respect to the first light source, and a third light source that is arranged in a second direction intersecting the optical axis and the first direction with respect to the first light source, and
   a center line of light emitted from the first light source intersects at least one of a center line of light emitted from the second light source or a center line of light emitted from the third light source.
(((10))) The light emitting device according to (((9))),
   wherein the center line of the light emitted from the first light source intersects both the center line of the light emitted from the second light source and the center line of the light emitted from the third light source.
(((11))) A light emitting device comprising:
   a light emitting unit that emits light;
   an optical system that expands an irradiation range of the light emitted from the light emitting unit as a distance from the light emitting unit increases; and
   a plurality of light sources each having the light emitting unit and the optical system and irradiating different irradiation regions with light beams,
   wherein an arrangement of the plurality of light sources and an arrangement of a plurality of irradiation regions that are irradiated with light beams from the plurality of light sources on an irradiation surface that is at a predetermined distance from the plurality of light sources and that is irradiated with light beams from the light sources are reversed.
(((12))) A distance measurement apparatus comprising:
   the light emitting device according to any one of (((1))) to (((11)));
   a light receiving unit that receives light emitted from the light emitting device and reflected by a target object; and
   a distance measurement unit that measures a distance to the target object based on a result of the light reception by the light receiving unit.
(((13))) The distance measurement apparatus according to (((12))),
   wherein the light receiving unit receives reflected light at a position farther from the light emitting device than an intersection portion where the center lines of the light beams emitted from the plurality of light sources to the irradiation regions intersect each other.

With the light emitting device according to (((1))), it is possible to prevent a non-irradiation region, which is not irradiated with light, from being formed between different irradiation regions in a case where the irradiation regions are irradiated with light beams using the plurality of light sources, as compared with a case where the center lines of the light beams emitted from the plurality of light sources to the irradiation regions do not intersect each other.

With the light emitting device according to (((2))), it is possible to prevent the target object from being irradiated with an excessive amount of light as compared with a case where the intersection portion where the center lines of the light beams emitted from the plurality of light sources to the irradiation regions intersect each other is located outside the housing.

With the light emitting device according to (((3))), it is possible to prevent the amount of light beams emitted to the irradiation regions from being non-uniform as compared with a case where the light emitting sections that irradiate, with light beams, the irradiation sections adjacent each other in the different irradiation regions are simultaneously turned on.

With the light emitting device according to (((4))), it is possible to reduce a time required to irradiate all the irradiation sections with light beams in a case where the light emitting section of one light source that irradiates the first irradiation section with light is turned on, and the light emitting section of the other light source that irradiates the second irradiation section with light is not turned on, as compared with a case where the light emitting sections that irradiate, with light beams, the irradiation sections other than the first irradiation section and the second irradiation section are not turned on.

With the light emitting device according to (((5))), it is possible to prevent occurrence of an irradiation section, which is not irradiated with light, as compared with a case where the light emitting sections that irradiate, which light beams, the irradiation sections adjacent to each other in the different irradiation regions are not turned on with a temporal shift.

With the light emitting device according to (((6))), the non-irradiation region is less likely to be formed between the irradiation regions adjacent to each other as compared with a case where the relative positions of the optical system and the light emitting unit are not determined so that there is no gap between the different irradiation regions.

With the light emitting device according to (((7))), it is possible to narrow a range in which the non-irradiation region is formed as compared with a case where the center line of the light emitted from the first light source intersects only any one of the center lines of the light beams emitted from the plurality of second light sources.

With the light emitting device according to (((8))), it is possible to further narrow the range in which the non-irradiation region is formed as compared with a case where the positions of the intersection portions where the center line of the light emitted from the first light source and the center lines of the light beams emitted from the respective second light sources intersect each other are not coincident.

With the light emitting device according to (((9))), it is possible to narrow the range in which the non-irradiation region is formed as compared with a case where the center line of the light emitted from the first light source does not intersect the center line of the light emitted from the second light source or the third light source.

With the light emitting device according to (((10))), it is possible to narrow the range in which the non-irradiation region is formed as compared with a case where the center line of the light emitted from the first light source intersects only the center line of the light emitted from one of the second light source and the third light source.

With the light emitting device according to (((11))), it is possible to prevent a non-irradiation region, which is not irradiated with light, from being formed between different irradiation regions in a case where the irradiation regions are irradiated with light beams using the plurality of light sources, as compared with a case where the center lines of the light beams emitted from the plurality of light sources to the irradiation regions do not intersect each other.

With the distance measurement apparatus according to (((12))), it is possible to prevent a non-irradiation region, which is not irradiated with light, from being formed between different irradiation regions in a case where the irradiation regions are irradiated with light beams using the plurality of light sources, as compared with a case where the center lines of the light beams emitted from the plurality of light sources to the irradiation regions do not intersect each other.

With the distance measurement apparatus according to (((13))), it is possible to prevent excessive light from entering the light receiving unit as compared with a case where the light receiving unit receives the reflected light at the intersection portion where the center lines of the light beams intersect each other.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

### Brief Description of the Reference Symbols

1: distance measurement apparatus
3: optical device
4: light emitting unit
4A, 4B: light source
5: light receiving unit
6: light emission drive unit
7: light reception drive unit
8: control unit
41: light emitting chip
42: lens
100A, 100B: irradiation region
101A, 101B: center line

## Claims

1. A light emitting device comprising:
a light emitting unit that emits light;
an optical system that expands an irradiation range of the light emitted from the light emitting unit as a distance from the light emitting unit increases; and
a plurality of light sources each having the light emitting unit and the optical system and irradiating different irradiation regions with light beams, in which center lines of the light beams emitted from the light sources to the irradiation regions intersect each other.

2. The light emitting device according to claim 1, further comprising:
a housing that accommodates the plurality of light sources,
wherein an intersection portion where the center lines of the light beams emitted from the plurality of light sources to the irradiation regions intersect each other is located inside the housing.

3. The light emitting device according to claim 1 or 2,
wherein the light emitting unit of each of the light sources includes a plurality of light emitting sections that irradiate, with light beams, a plurality of irradiation sections into which an irradiation region is divided,
the light emitting device further comprises a drive unit that drives the light emitting unit of each of the light sources to individually turn on the plurality of light emitting sections of the light emitting unit, and
the drive unit does not simultaneously turn on the light emitting sections that irradiate, with light beams, the irradiation sections adjacent to each other in the different irradiation regions.

4. The light emitting device according to claim 3,
wherein, in the irradiation sections where the light beams emitted from the light sources to the irradiation regions overlap, the drive unit turns on a light emitting section of one light source that irradiates a first irradiation section, which is one of the irradiation sections, with light, does not turn on a light emitting section of the other light source that irradiates a second irradiation section, which is the other of the irradiation sections, with light, and turns on light emitting sections that irradiate, with light beams, irradiation sections other than the first irradiation section and the second irradiation section.

5. The light emitting device according to claim 3,
wherein the drive unit turns on the light emitting sections that irradiate, with light beams, the irradiation sections adjacent to each other in the different irradiation regions, with a temporal shift.

6. The light emitting device according to any one of claims 1 to 5,
wherein optical systems and light emitting units of the plurality of light sources have the same characteristics, and
the plurality of light sources have different relative positions of the optical system and the light emitting unit so that there is no gap between the different irradiation regions in a case where a distance from the plurality of light sources is a predetermined reference distance.

7. The light emitting device according to any one of claims 1 to 6,
wherein the plurality of light sources include a first light source, and a plurality of second light sources that are arranged in a first direction intersecting an optical axis of the optical system with respect to the first light source, and
a center line of light emitted from the first light source intersects any of center lines of light beams emitted from the plurality of second light sources.

8. The light emitting device according to claim 7,
wherein positions of intersection portions where the center line of the light emitted from the first light source and the center lines of the light beams emitted from the respective second light sources intersect each other are coincident.

9. The light emitting device according to any one of claims 1 to 6,
wherein the plurality of light sources include a first light source, a second light source that is arranged in a first direction intersecting an optical axis of the optical system with respect to the first light source, and a third light source that is arranged in a second direction intersecting the optical axis and the first direction with respect to the first light source, and
a center line of light emitted from the first light source intersects at least one of a center line of light emitted from the second light source or a center line of light emitted from the third light source.

10. The light emitting device according to claim 9,
wherein the center line of the light emitted from the first light source intersects both the center line of the light emitted from the second light source and the center line of the light emitted from the third light source.

11. Alight emitting device comprising:
a light emitting unit that emits light;
an optical system that expands an irradiation range of the light emitted from the light emitting unit as a distance from the light emitting unit increases; and
a plurality of light sources each having the light emitting unit and the optical system and irradiating different irradiation regions with light beams,
wherein an arrangement of the plurality of light sources and an arrangement of a plurality of irradiation regions that are irradiated with light beams from the plurality of light sources on an irradiation surface that is at a predetermined distance from the plurality of light sources and that is irradiated with light beams from the light sources are reversed.

12. A distance measurement apparatus comprising:
the light emitting device according to any one of claims 1 to 11;
a light receiving unit that receives light emitted from the light emitting device and reflected by a target object; and
a distance measurement unit that measures a distance to the target object based on a result of the light reception by the light receiving unit.

13. The distance measurement apparatus according to claim 12,
wherein the light receiving unit receives reflected light at a position farther from the light emitting device than an intersection portion where the center lines of the light beams emitted from the plurality of light sources to the irradiation regions intersect each other.
